# EUROPEAN PATENT SPECIFICATION

(11) **EP 4 202 011 B1**
(45) Date of publication and mention of the grant of the patent: **29.04.2026**
(21) Application number: 21869622.7
(22) Date of filing: 08.09.2021
(51) Int. Cl.: C07F 5/02, C09K 11/06, C07F 5/06, C07F 9/6584, C07F 7/08, H10K 99/00, H10K 59/00, H10K 50/00, H10K 50/11, H10K 50/15, H10K 50/16, H10K 50/17, H10K 50/18

(54) **POLYCYCLIC AROMATIC DERIVATIVE COMPOUND AND ORGANOELECTROLUMINESCENT DEVICE USING SAME**
POLYCYCLISCHE AROMATISCHE DERIVATVERBINDUNG UND ORGANOELEKTROLUMINESZENZVORRICHTUNG DAMIT
COMPOSÉ DÉRIVÉ AROMATIQUE POLYCYCLIQUE ET DISPOSITIF ÉLECTROLUMINESCENT ORGANIQUE L'UTILISANT

(30) Priority: 15.09.2020 KR 20200118180
(43) Date of publication of application: 28.06.2023
(73) Proprietor: SFC Co., Ltd., Cheongju-si, Chungcheongbuk-do 28122 (KR)
(72) Inventor: SHIN, Bong-ki, Cheongju-si Chungcheongbuk-do 28122 (KR); JOO, Sung-hoon, Cheongju-si Chungcheongbuk-do 28122 (KR); YANG, Byung-sun, Cheongju-si Chungcheongbuk-do 28122 (KR); KIM, Ji-hwan, Cheongju-si Chungcheongbuk-do 28122 (KR); JO, Hyeon-jun, Cheongju-si Chungcheongbuk-do 28122 (KR); CHOI, Sung-eun, Cheongju-si Chungcheongbuk-do 28122 (KR)
(74) Representative: Grosse, Felix Christopher
(86) International application number: PCT/KR2021/012228
(87) International publication number: WO 2022/060000

(56) References cited:
- EP-A1- 3 660 024
- EP-A1- 4 238 976
- CN-A- 110 790 782
- KR-A- 20190 101 900
- KR-A- 20190 140 421
- KR-A- 20200 034 899
- KR-A- 20210 043 468
- KR-B1- 102 094 830

## Description

### Technical Field

The present invention relates to a polycyclic aromatic derivative and a highly efficient and long-lasting organic electroluminescent device with significantly improved luminous efficiency using the polycyclic aromatic derivative.

### Background Art

Organic electroluminescent devices are self-luminous devices in which electrons injected from an electron injecting electrode (cathode) recombine with holes injected from a hole injecting electrode (anode) in a light emitting layer to form excitons, which emit light while releasing energy. Such organic electroluminescent devices have the advantages of low driving voltage, high luminance, large viewing angle, and short response time and can be applied to full-color light emitting flat panel displays. Due to these advantages, organic electroluminescent devices have received attention as next-generation light sources.

The above characteristics of organic electroluminescent devices are achieved by structural optimization of organic layers of the devices and are supported by stable and efficient materials for the organic layers, such as hole injecting materials, hole transport materials, light emitting materials, electron transport materials, electron injecting materials, and electron blocking materials. In EP3660024A1, examples of polycyclic aromatic compounds are described that can be employed in various organic layers of organic electroluminescent devices. However, more research still needs to be done to develop structurally optimized organic layers for organic electroluminescent devices and stable and efficient materials for organic layers of organic electroluminescent devices.

As such, there is a continued need to develop structures of organic electroluminescent devices optimized to improve their luminescent properties and new materials capable of supporting the optimized structures of organic electroluminescent devices.

### Problems to be Solved by the Invention

Accordingly, the present invention is intended to provide a polycyclic aromatic derivative that is employed in an organic layer of an organic electroluminescent device to achieve high efficiency and long lifetime of the device. The present invention is also intended to provide an organic electroluminescent device including the polycyclic aromatic derivative.

### Means for Solving the Problems

One aspect of the present invention provides a polycyclic aromatic derivative represented by Formula A:

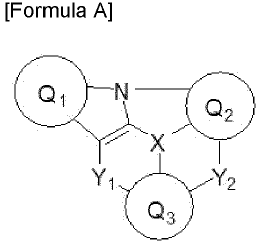

The structure of Formula A, specific compounds that can be represented by Formula A, and definitions of the rings Q₁ to Q₃, X, Y₁, and Y₂ are described below.

The present invention also provides an organic electroluminescent device including a first electrode, a second electrode opposite to the first electrode, and one or more organic layers interposed between the first and second electrodes wherein one of the organic layers includes at least one of the specific polycyclic aromatic compounds that can be represented by Formula A.

### Effects of the Invention

The polycyclic aromatic derivative of the present invention can be employed in an organic layer of an organic electroluminescent device to achieve high efficiency and long lifetime of the device.

The present invention will now be described in more detail.

The present invention is directed to a polycyclic aromatic derivative for use in an organic electroluminescent device, represented by Formula A: 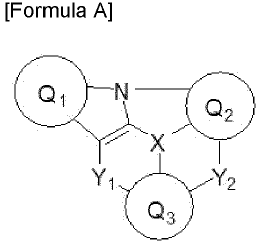 wherein Q₁ is selected from substituted or unsubstituted C₆-C₅₀ monocyclic or polycyclic aromatic hydrocarbon rings, substituted or unsubstituted C₂-C₅₀ monocyclic or polycyclic aromatic heterocyclic rings, substituted or unsubstituted C₆-C₅₀ monocyclic or polycyclic aliphatic hydrocarbon rings, and substituted or unsubstituted C₂-C₅₀ monocyclic or polycyclic aliphatic heterocyclic rings, Q₂ and Q₃ are the same as or different from each other and are each independently selected from substituted or unsubstituted C₆-C₅₀ monocyclic or polycyclic aromatic hydrocarbon rings and substituted or unsubstituted C₂-C₅₀ monocyclic or polycyclic aromatic heterocyclic rings, X is B, Y₁ and Y₂ are the same as or different from each other and are each independently a single bond or selected from 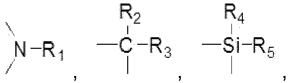 -O-, -S-, and -Se-, and R₁ to R₅ are the same as or different from each other and are each independently selected from hydrogen, deuterium, substituted or unsubstituted C₁-C₃₀ alkyl, substituted or unsubstituted C₁-C₃₀ alkenyl, substituted or unsubstituted C₆-C₅₀ aryl, substituted or unsubstituted C₃-C₃₀ cycloalkyl, substituted or unsubstituted C₂-C₃₀ heterocycloalkyl, substituted or unsubstituted C₂-C₅₀ heteroaryl, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₅-C₃₀ arylthioxy, substituted or unsubstituted amine, substituted or unsubstituted silyl, nitro, cyano, and halogen, with the proviso that each of R₁ to R₅ is optionally bonded to at least one of the rings Q₁ to Q₃ to form an alicyclic or aromatic monocyclic or polycyclic ring, R₂ and R₃ are optionally linked to each other to form an alicyclic or aromatic monocyclic or polycyclic ring, and R₄ and R₅ are optionally linked to each other to form an alicyclic or aromatic monocyclic or polycyclic ring.

The use of the polycyclic aromatic derivative makes the organic electroluminescent device highly efficient and long lasting.

Specific structures of Formula A and modified structures of Formula A including additional rings within the definitions of the substituents can be found in the specific compounds that are exemplified below.

As used herein, the term "substituted" in the definition of the rings Q₄ to Q₃ and R₁ to R₅ indicates substitution with one or more substituents selected from deuterium, cyano, halogen, hydroxyl, nitro, alkyl, haloalkyl, cycloalkyl, alkenyl, alkynyl, heteroalkyl, aryl, arylalkyl, alkylaryl, heteroaryl, heteroarylalkyl, alkoxy, amine, silyl, aryloxy, and mixed aliphatic-aromatic cyclic groups, or a combination thereof. As used herein, the term "unsubstituted" in the same definition indicates having no substituent.

In the "substituted or unsubstituted C₁-C₃₀ alkyl", "substituted or unsubstituted C₆-C₅₀ aryl", etc., the number of carbon atoms in the alkyl or aryl group indicates the number of carbon atoms constituting the unsubstituted alkyl or aryl moiety without considering the number of carbon atoms in the substituent(s). For example, a phenyl group substituted with a butyl group at the para-position corresponds to a C₆ aryl group substituted with a C₄ butyl group.

As used herein, the expression "form a ring with an adjacent substituent" means that the corresponding substituent combines with an adjacent substituent to form a substituted or unsubstituted alicyclic or aromatic ring and the term "adjacent substituent" may mean a substituent on an atom directly attached to an atom substituted with the corresponding substituent, a substituent disposed sterically closest to the corresponding substituent or another substituent on an atom substituted with the corresponding substituent. For example, two substituents substituted at the ortho position of a benzene ring or two substituents on the same carbon in an aliphatic ring may be considered "adjacent" to each other.

The alkyl groups may be straight or branched and specific examples thereof include, but are not limited to, methyl, ethyl, propyl, n-propyl, isopropyl, butyl, n-butyl, isobutyl, tert-butyl, sec-butyl, 1-methylbutyl, 1-ethylbutyl, pentyl, n-pentyl, isopentyl, neopentyl, tert-pentyl, hexyl, n-hexyl, 1-methylpentyl, 2-methylpentyl, 4-methyl-2-pentyl, 3,3-dimethylbutyl, 2-ethylbutyl, heptyl, n-heptyl, 1-methylhexyl, cyclopentylmethyl, cyclohexylmethyl, octyl, n-octyl, tert-octyl, 1-methylheptyl, 2-ethylhexyl, 2-propylpentyl, n-nonyl, 2,2-dimethylheptyl, 1-ethylpropyl, 1,1-dimethylpropyl, isohexyl, 2-methylpentyl, 4-methylhexyl, and 5-methylhexyl groups.

The alkenyl group is intended to include straight and branched ones and may be optionally substituted with one or more other substituents. The alkenyl group may be specifically a vinyl, 1-propenyl, isopropenyl, 1-butenyl, 2-butenyl, 3-butenyl, 1-pentenyl, 2-pentenyl, 3-pentenyl, 3-methyl-1-butenyl, 1,3-butadienyl, allyl, 1-phenylvinyl-1-yl, 2-phenylvinyl-1-yl, 2,2-diphenylvinyl-1-yl, 2-phenyl-2-(naphthyl-1-yl)vinyl-1-yl, 2,2-bis(diphenyl-1-yl)vinyl-1-yl, stilbenyl or styrenyl group but is not limited thereto.

The alkynyl group is intended to include straight and branched ones and may be optionally substituted with one or more other substituents. The alkynyl group may be, for example, ethynyl or 2-propynyl but is not limited thereto.

The cycloalkyl group is intended to include monocyclic and polycyclic ones and may be optionally substituted with one or more other substituents. As used herein, the term "polycyclic" means that the cycloalkyl group may be directly attached or fused to one or more other cyclic groups. The other cyclic groups may be cycloalkyl groups and other examples thereof include heterocycloalkyl, aryl, and heteroaryl groups. The cycloalkyl group may be specifically a cyclopropyl, cyclobutyl, cyclopentyl, adamantyl, 3-methylcyclopentyl, 2,3-dimethylcyclopentyl, cyclohexyl, 3-methylcyclohexyl, 4-methylcyclohexyl, 2,3-dimethylcyclohexyl, 3,4,5-trimethylcyclohexyl, 4-tert-butylcyclohexyl, cycloheptyl or cyclooctyl group but is not limited thereto.

The heterocycloalkyl group is intended to include monocyclic and polycyclic ones interrupted by a heteroatom such as O, S, Se, N or Si and may be optionally substituted with one or more other substituents. As used herein, the term "polycyclic" means that the heterocycloalkyl group may be directly attached or fused to one or more other cyclic groups. The other cyclic groups may be heterocycloalkyl groups and other examples thereof include cycloalkyl, aryl, and heteroaryl groups.

The aromatic hydrocarbon rings or aryl groups may be monocyclic or polycyclic ones. Examples of the monocyclic aryl groups include, but are not limited to, phenyl, biphenyl, terphenyl, and stilbenyl groups. Examples of the polycyclic aryl groups include naphthyl, anthracenyl, phenanthrenyl, pyrenyl, perylenyl, tetracenyl, chrysenyl, fluorenyl, acenaphathcenyl, triphenylene, and fluoranthrene groups but the scope of the present invention is not limited thereto.

The aromatic heterocyclic rings or heteroaryl groups refer to aromatic rings interrupted by one or more heteroatoms. Examples of the aromatic heterocyclic rings or heteroaryl groups include, but are not limited to, thiophene, furan, pyrrole, imidazole, thiazole, oxazole, oxadiazole, triazole, pyridyl, bipyridyl, pyrimidyl, triazine, triazole, acridyl, pyridazine, pyrazinyl, quinolinyl, quinazoline, quinoxalinyl, phthalazinyl, pyridopyrimidinyl, pyridopyrazinyl, pyrazinopyrazinyl, isoquinoline, indole, carbazole, benzoxazole, benzimidazole, benzothiazole, benzocarbazole, benzothiophene, dibenzothiophene, benzofuranyl, dibenzofuranyl, phenanthroline, thiazolyl, isoxazolyl, oxadiazolyl, thiadiazolyl, benzothiazolyl, and phenothiazinyl groups.

The aliphatic hydrocarbon rings refer to non-aromatic rings consisting only of carbon and hydrogen atoms. The aliphatic hydrocarbon ring is intended to include monocyclic and polycyclic ones and may be optionally substituted with one or more other substituents. As used herein, the term "polycyclic" means that the aliphatic hydrocarbon ring may be directly attached or fused to one or more other cyclic groups. The other cyclic groups may be aliphatic hydrocarbon rings and other examples thereof include aliphatic heterocyclic, aryl, and heteroaryl groups. Specific examples of the aliphatic hydrocarbon rings include, but are not limited to, cycloalkyl groups such as cyclopropyl, cyclobutyl, cyclopentyl, adamantyl, 3-methylcyclopentyl, 2,3-dimethylcyclopentyl, cyclohexyl, 3-methylcyclohexyl, 4-methylcyclohexyl, 2,3-dimethylcyclohexyl, 3,4,5-trimethylcyclohexyl, 4-tert-butylcyclohexyl, cycloheptyl, and cyclooctyl, cycloalkanes such as cyclohexane and cyclopentane, and cycloalkenes such as cyclohexene and cyclopentene.

The aliphatic heterocyclic rings refer to aliphatic rings interrupted by one or more heteroatoms such as O, S, Se, N, and Si. The aliphatic heterocyclic ring is intended to include monocyclic or polycyclic ones and may be optionally substituted with one or more other substituents. As used herein, the term "polycyclic" means that the aliphatic heterocyclic ring such as heterocycloalkyl, heterocycloalkane or heterocycloalkene may be directly attached or fused to one or more other cyclic groups. The other cyclic groups may be aliphatic heterocyclic rings and other examples thereof include aliphatic hydrocarbon rings, aryl groups, and heteroaryl groups.

The mixed aliphatic-aromatic ring refers to a ring in which at least one aliphatic ring and at least one aromatic ring are linked or fused together and which is overall non-aromatic. The mixed aliphatic-aromatic polycyclic ring may contain one or more heteroatoms selected from N, O, P, and S other than carbon atoms (C).

The alkoxy group may be specifically a methoxy, ethoxy, propoxy, isobutyloxy, sec-butyloxy, pentyloxy, iso-amyloxy or hexyloxy group but is not limited thereto.

The silyl groups may be, for example, -SiH₃, alkylsilyl, arylsilyl, alkylarylsilyl, and arylheteroarylsilyl. Specific examples of the silyl groups include trimethylsilyl, triethylsilyl, triphenylsilyl, trimethoxysilyl, dimethoxyphenylsilyl, diphenylmethylsilyl, diphenylvinylsilyl, methylcyclobutylsilyl, and dimethylfurylsilyl.

The amine groups may be, for example, -NH₂, alkylamine groups, arylamine groups, and arylheteroarylamine groups. The arylamine groups refer to aryl-substituted amine groups, the alkylamine groups refer to alkyl-substituted amine groups, and the arylheteroarylamine groups refer to aryl- and heteroaryl-substituted amine groups. Examples of the arylamine groups include substituted or unsubstituted monoarylamine groups, substituted or unsubstituted diarylamine groups, and substituted or unsubstituted triarylamine groups. The aryl and heteroaryl moieties in the arylamine and arylheteroarylamine groups may be monocyclic or polycyclic ones. The arylamine groups may include two or more aryl moieties and the arylheteroarylamine groups may include two or more heteroaryl moieties. In this case, the aryl moieties may be monocyclic or polycyclic aryl moieties or may consist of both monocyclic and polycyclic aryl moieties. The heteroaryl moieties may be monocyclic or polycyclic heteroaryl moieties or may consist of both monocyclic and polycyclic heteroaryl moieties. The aryl and heteroaryl moieties in the arylamine and arylheteroarylamine groups may be selected from those exemplified above.

The aryl moieties in the aryloxy group and the arylthioxy group are the same as those described above for the aryl groups. Specific examples of the aryloxy groups include, but are not limited to, phenoxy, p-tolyloxy, m-tolyloxy, 3,5-dimethylphenoxy, 2,4,6-trimethylphenoxy, p-tert-butylphenoxy, 3-biphenyloxy, 4-biphenyloxy, 1-naphthyloxy, 2-naphthyloxy, 4-methyl-1-naphthyloxy, 5-methyl-2-naphthyloxy, 1-anthryloxy, 2-anthryloxy, 9-anthryloxy, 1-phenanthryloxy, 3-phenanthryloxy, and 9-phenanthryloxy groups. The arylthioxy group may be, for example, a phenylthioxy, 2-methylphenylthioxy or 4-tert-butylphenylthioxy group but is not limited thereto.

The halogen group may be, for example, fluorine, chlorine, bromine or iodine.

More specifically, the polycyclic aromatic derivative represented by Formula A according to the present invention may be selected from, but not limited to, the following compounds 1 to 72:

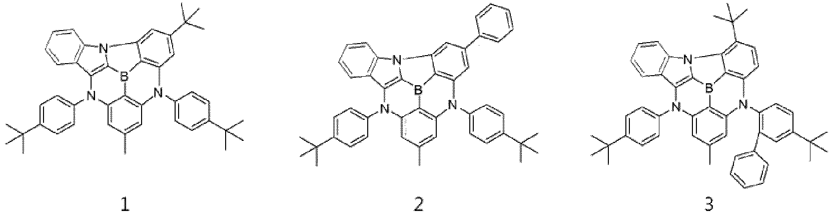

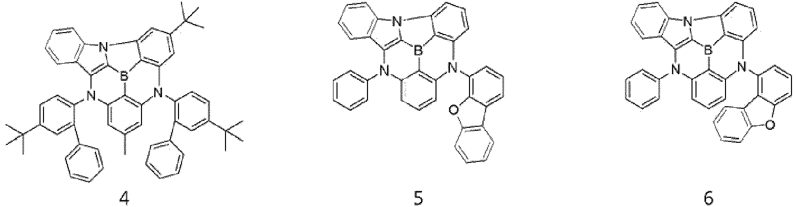

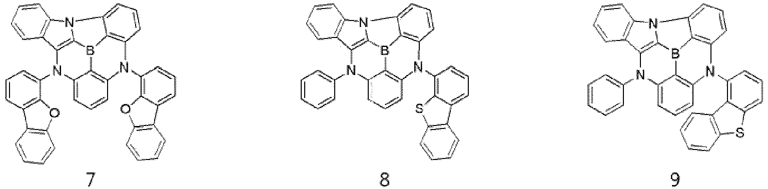

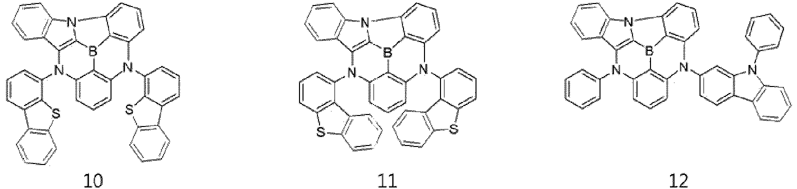

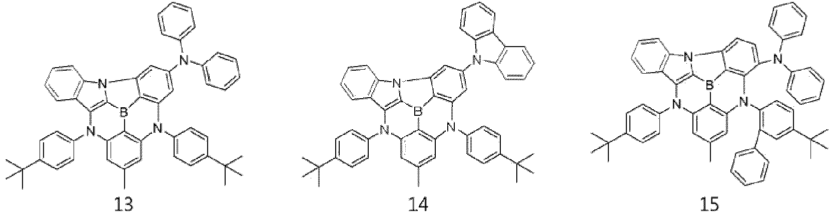

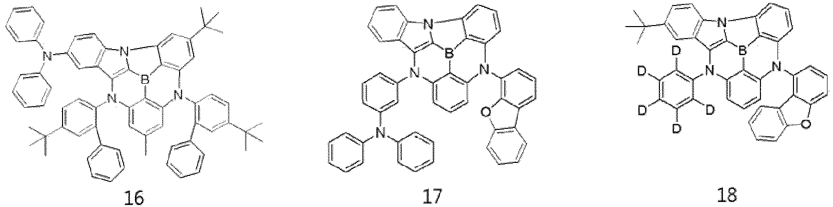

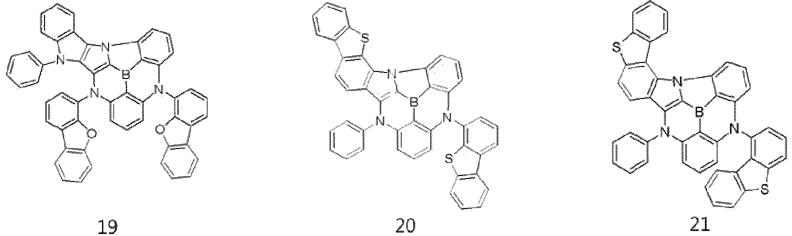

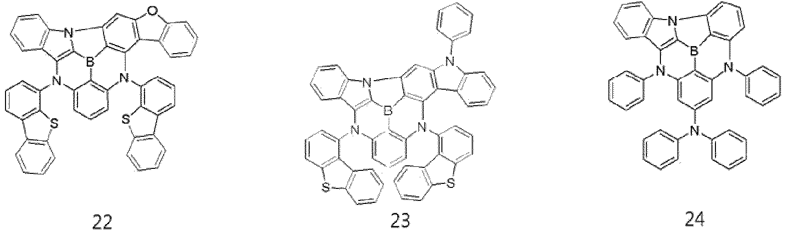

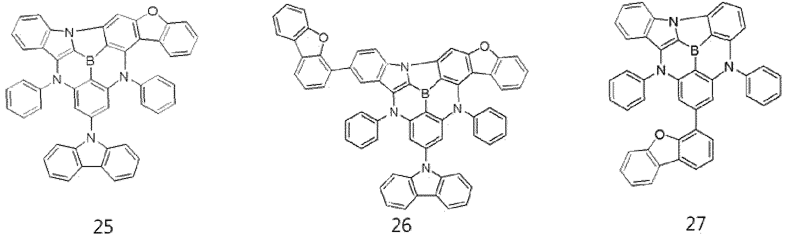

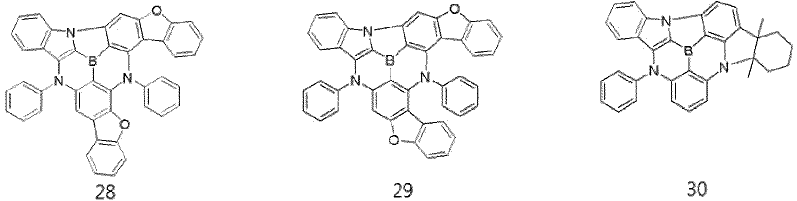

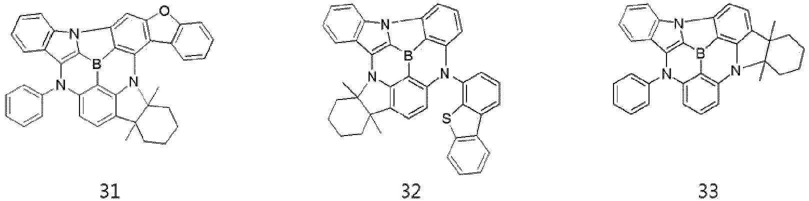

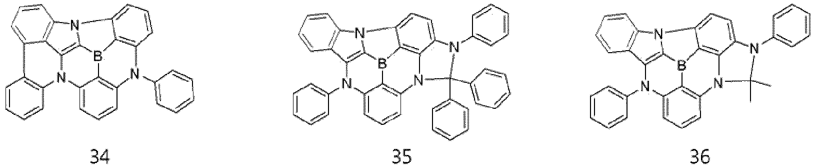

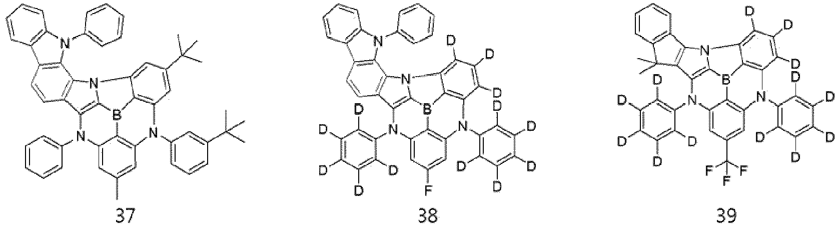

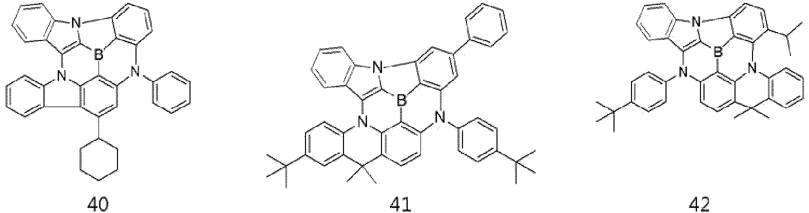

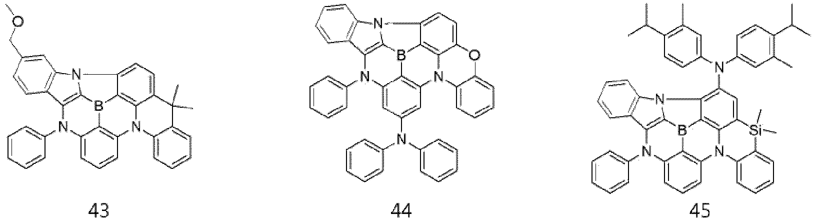

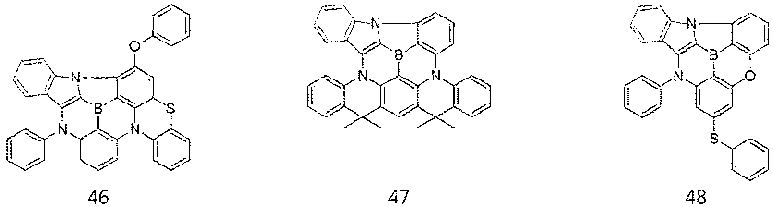

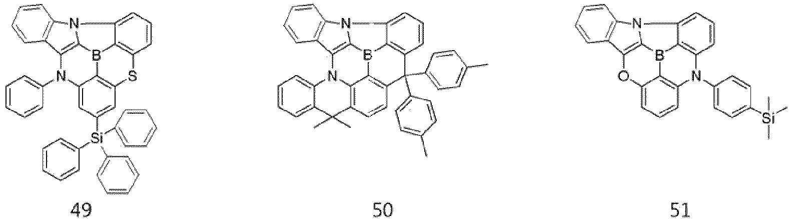

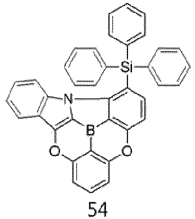

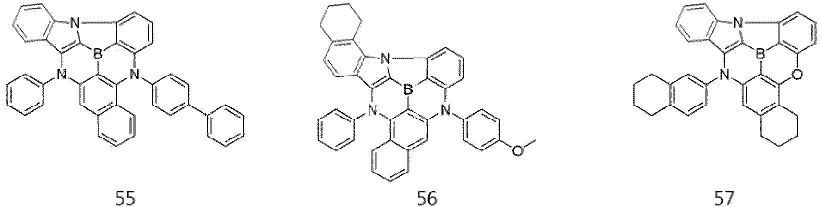

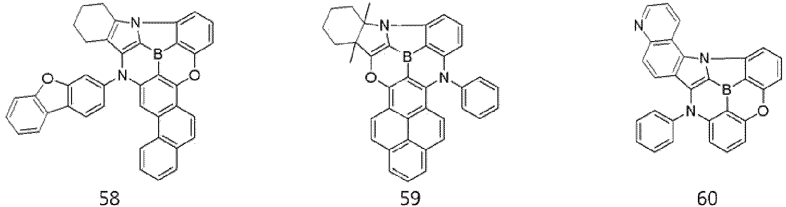

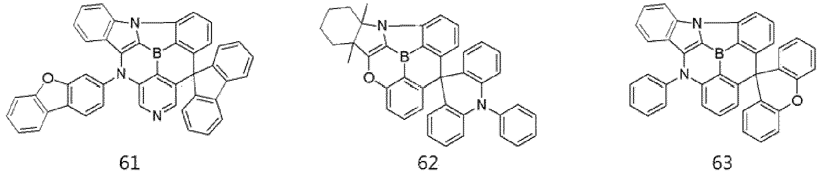

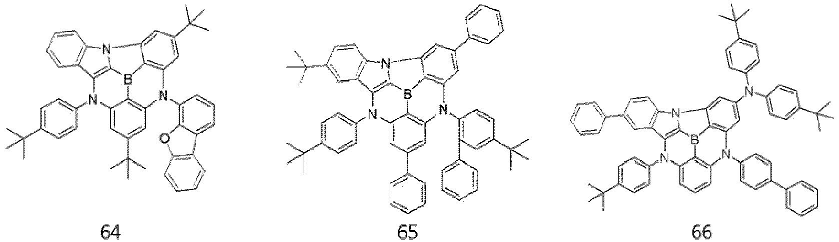

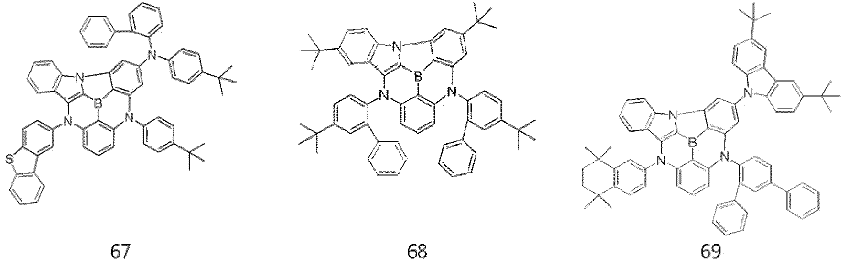

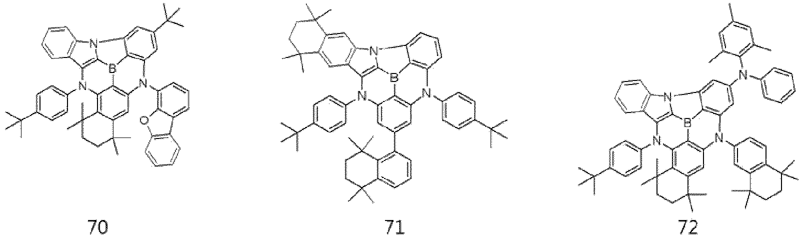

The specific substituents in Formula A can be clearly seen from the structures of the compounds 1 to 72 but are not intended to limit the scope of the compound represented by Formula A.

As can be seen from the above specific compounds, the polycyclic aromatic derivative of the present invention contains B and has a polycyclic aromatic structure. The introduction of substituents into the polycyclic aromatic structure enables the synthesis of organic materials with inherent characteristics of the substituents. For example, the substituents are designed for use in materials for hole injecting layers, hole transport layers, light emitting layers, electron transport layers, electron injecting layers, electron blocking layers, and hole blocking layers of organic electroluminescent devices. This introduction meets the requirements of materials for the organic layers, making the organic electroluminescent devices highly efficient.

A further aspect of the present invention is directed to an organic electroluminescent device including a first electrode, a second electrode, and one or more organic layers interposed between the first and second electrodes wherein one of the organic layers includes at least one of the organic electroluminescent compounds that can be represented by Formula A.

That is, according to one embodiment of the present invention, the organic electroluminescent device has a structure in which one or more organic layers are arranged between a first electrode and a second electrode. The organic electroluminescent device of the present invention may be fabricated by a suitable method known in the art using suitable materials known in the art, except that the organic electroluminescent compound of Formula A is used to form the corresponding organic layer.

The organic layers of the organic electroluminescent device according to the present invention may form a monolayer structure. Alternatively, the organic layers may have a multilayer stack structure. For example, the organic layers may have a structure including a hole injecting layer, a hole transport layer, a hole blocking layer, a light emitting layer, an electron blocking layer, an electron transport layer, and an electron injecting layer but are not limited to this structure. The number of the organic layers is not limited and may be increased or decreased. Preferred structures of the organic layers of the organic electroluminescent device according to the present invention will be explained in more detail in the Examples section that follows.

The organic electroluminescent device of the present invention includes an anode, a hole transport layer, a light emitting layer, an electron transport layer, and a cathode. The organic electroluminescent device of the present invention may optionally further include a hole injecting layer between the anode and the hole transport layer and an electron injecting layer between the electron transport layer and the cathode. If necessary, the organic electroluminescent device of the present invention may further include one or two intermediate layers such as a hole blocking layer or an electron blocking layer.

According to a preferred embodiment of the present invention, one of the organic layers interposed between the first and second electrodes may be a light emitting layer composed of a host and the compound represented by Formula A as a dopant.

The content of the dopant in the light emitting layer is typically in the range of about 0.01 to about 20 parts by weight, based on about 100 parts by weight of the host but is not limited to this range.

According to a preferred embodiment of the present invention, the host may be an anthracene derivative represented by Formula C: 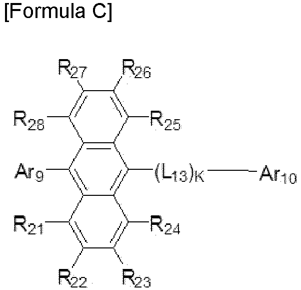 wherein R₂₁ to R₂₈ are identical to or different from each other and are as defined for R in Formula A, Ar₉ and Ar₁₀ are identical to or different from each other and are each independently selected from hydrogen, deuterium, substituted or unsubstituted C₁-C₃₀ alkyl, substituted or unsubstituted C₆-C₅₀ aryl, substituted or unsubstituted C₂-C₃₀ alkenyl, substituted or unsubstituted C₂-C₂₀ alkynyl, substituted or unsubstituted C₃-C₃₀ cycloalkyl, substituted or unsubstituted C₅-C₃₀ cycloalkenyl, substituted or unsubstituted C₂-C₅₀ heteroaryl, substituted or unsubstituted C₂-C₃₀ heterocycloalkyl, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₆-C₃₀ arylthioxy, halogen, substituted or unsubstituted amine, and substituted or unsubstituted silyl, L₁₃ is a single bond or is selected from substituted or unsubstituted C₆-C₂₀ arylene and substituted or unsubstituted C₂-C₂₀ heteroarylene, and k is an integer from 1 to 3, provided that when k is 2 or more, the linkers L₁₃ are identical to or different from each other.

According to one embodiment of the present invention, Ar₉ in Formula C may be a substituted or unsubstituted phenyl group or a substituted or unsubstituted naphthyl group.

According to one embodiment of the present invention, the host represented by Formula C may be selected from, but not limited to, the compounds of Formulae C1 to C69:

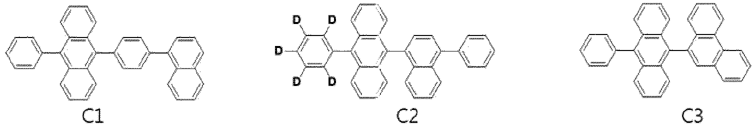

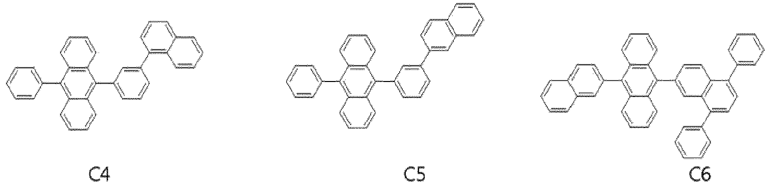

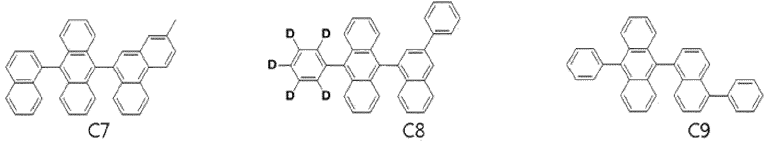

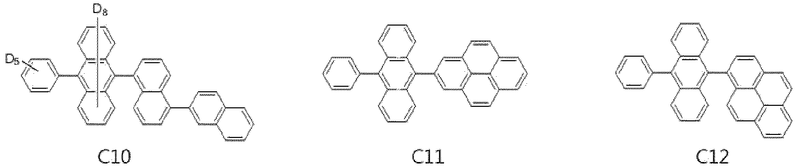

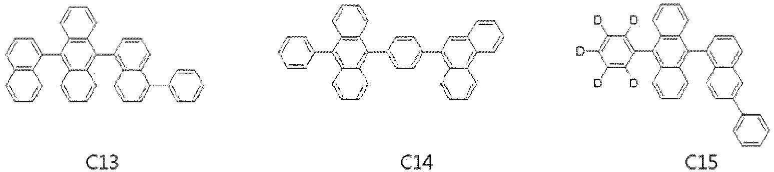

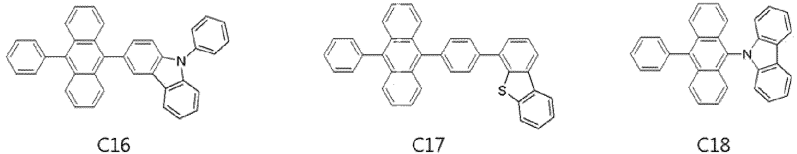

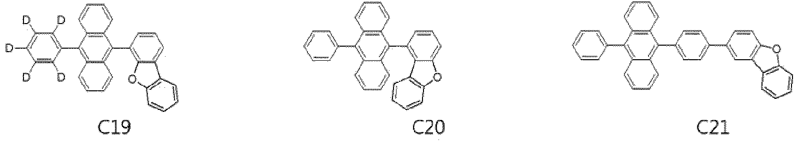

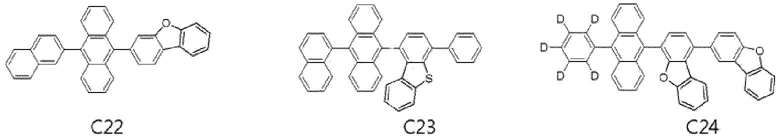

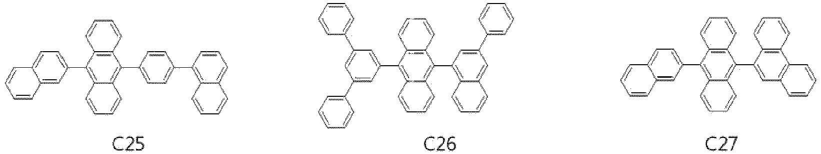

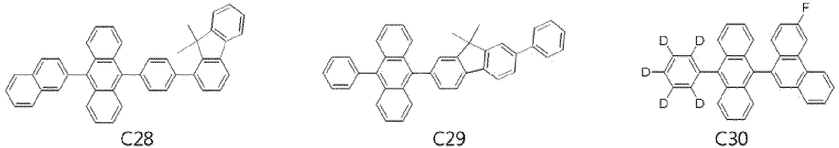

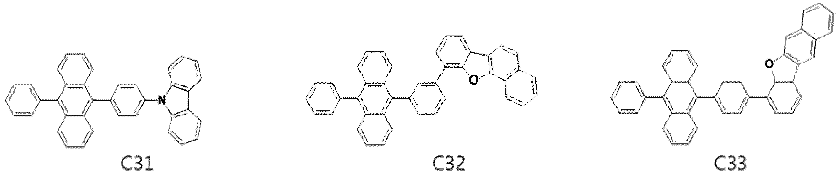

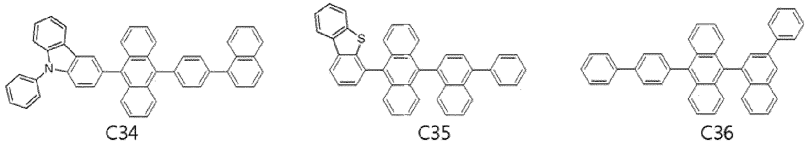

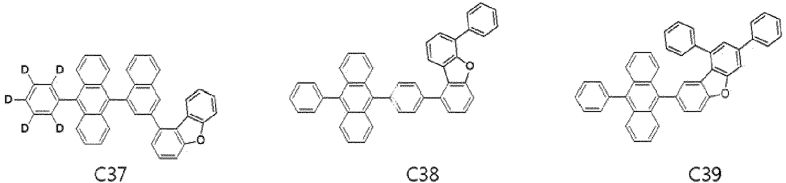

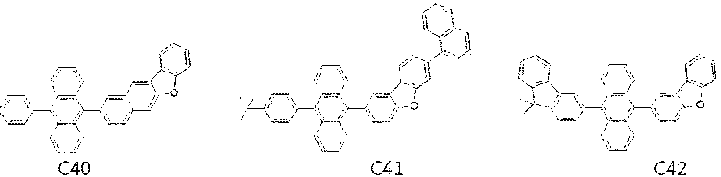

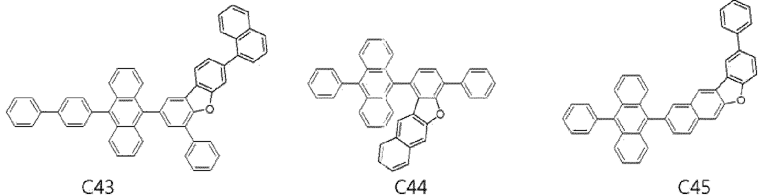

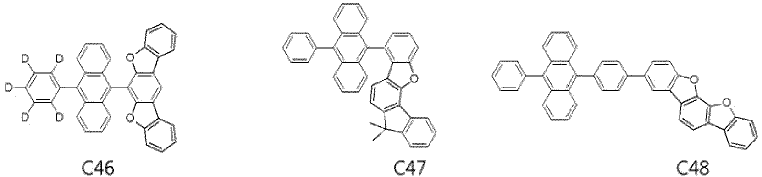

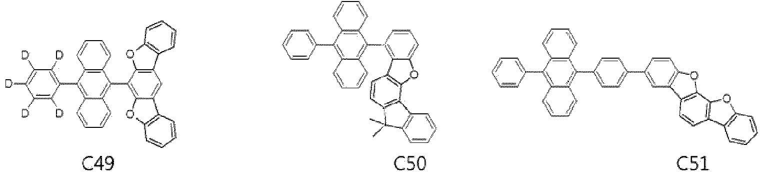

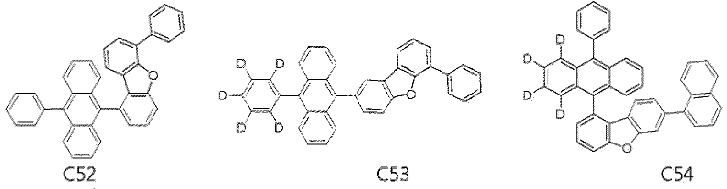

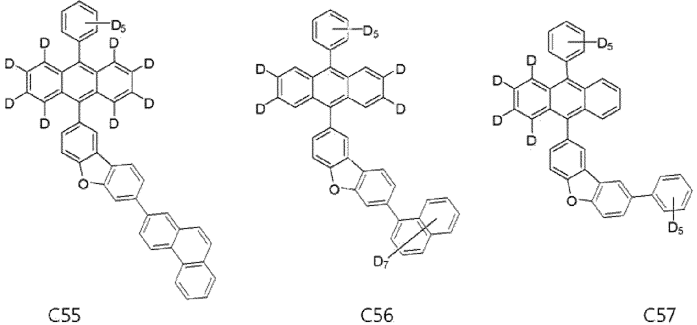

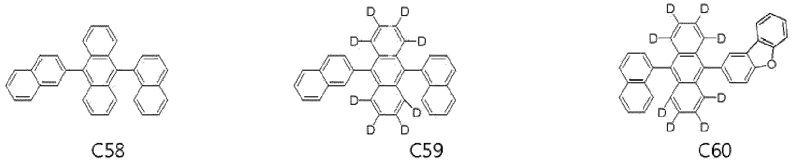

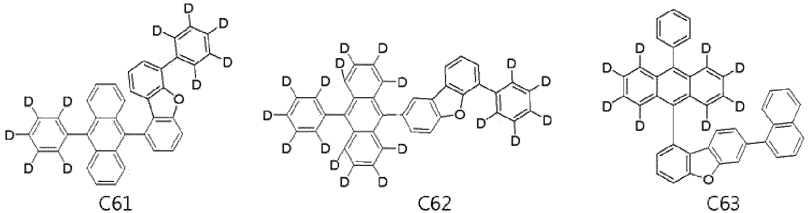

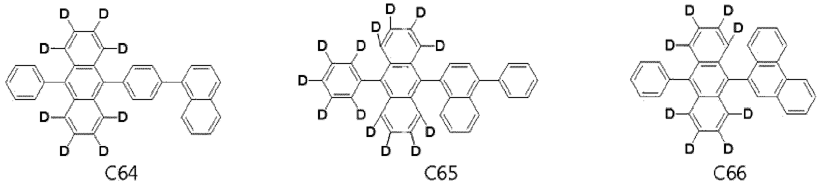

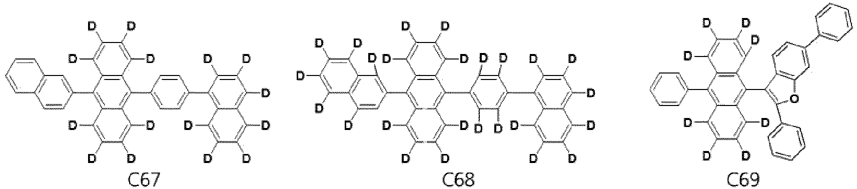

A specific structure of the organic electroluminescent device according to the present invention, a method for fabricating the device, and materials for the organic layers will be described below.

First, an anode material is coated on a substrate to form an anode. The substrate may be any of those used in general organic electroluminescent devices. The substrate is preferably an organic substrate or a transparent plastic substrate that is excellent in transparency, surface smoothness, ease of handling, and waterproofness. A highly transparent and conductive metal oxide such as indium tin oxide (ITO), indium zinc oxide (IZO), tin oxide (SnO₂) or zinc oxide (ZnO) is used as the anode material.

A hole injecting material is coated on the anode by vacuum thermal evaporation or spin coating to form a hole injecting layer. Then, a hole transport material is coated on the hole injecting layer by vacuum thermal evaporation or spin coating to form a hole transport layer.

The hole injecting material is not specially limited as long as it is usually used in the art. Specific examples of such materials include 4,4',4"-tris(2-naphthylphenyl-phenylamino)triphenylamine (2-TNATA), N,N'-di(1-naphthyl)-N,N'-diphenylbenzidine (NPD), N,N'-diphenyl-N,N'-bis(3-methylphenyl)-1,1'-biphenyl-4,4'-diamine (TPD), N,N'-diphenyl-N,N'-bis(4-(phenyl-m-tolylamino)phenyl)biphenyl-4,4'-diamine (DNTPD), and 1,4,5,8,9,11-hexaazatriphenylenehexacarbonitrile (HAT-CN).

The hole transport material is not specially limited as long as it is commonly used in the art. Examples of such materials include N,N'-bis(3-methylphenyl)-N,N'-diphenyl-(1,1-biphenyl)-4,4'-diamine (TPD) and N,N'-di(naphthalen-1-yl)-N,N'-diphenylbenzidine (α-NPD).

Subsequently, a hole auxiliary layer and a light emitting layer are sequentially formed on the hole transport layer. A hole blocking layer may be optionally formed on the light emitting layer by vacuum thermal evaporation or spin coating. The hole blocking layer is formed as a thin film. The hole blocking layer plays a role in blocking holes from entering a cathode through the organic light emitting layer. This role prevents the lifetime and efficiency of the device from deteriorating. To this end, a material having a very low highest occupied molecular orbital (HOMO) energy level is used for the hole blocking layer. The hole blocking material is not particularly limited as long as it can transport electrons and has a higher ionization potential than the light emitting compound. Representative examples of suitable hole blocking materials include BAlq, BCP, and TPBI.

Examples of materials for the hole blocking layer include, but are not limited to, BAlq, BCP, Bphen, TPBI, NTAZ, BeBq₂, OXD-7, and Liq.

An electron transport layer is deposited on the hole blocking layer by vacuum thermal evaporation or spin coating, and an electron injecting layer is formed thereon. A cathode metal is deposited on the electron injecting layer by vacuum thermal evaporation to form a cathode, completing the fabrication of the organic electroluminescent device.

For example, lithium (Li), magnesium (Mg), aluminum (Al), aluminum-lithium (Al-Li), calcium (Ca), magnesium-indium (Mg-In) or magnesium-silver (Mg-Ag) may be used as the metal for the formation of the cathode. The organic electroluminescent device may be of top emission type. In this case, a transmissive material such as ITO or IZO may be used to form the cathode.

A material for the electron transport layer functions to stably transport electrons injected from the cathode. The electron transport material may be any of those known in the art and examples thereof include, but are not limited to, quinoline derivatives, particularly tris(8-quinolinolate)aluminum (Alq3), TAZ, Balq, beryllium bis(benzoquinolin-10-olate) (Bebq2), and oxadiazole derivatives such as PBD, BMD, and BND.

Each of the organic layers can be formed by a monomolecular deposition or solution process. According to the monomolecular deposition process, the material for each layer is evaporated into a thin film under heat and vacuum or reduced pressure. According to the solution process, the material for each layer is mixed with a suitable solvent, and then the mixture is formed into a thin film by a suitable method such as ink-jet printing, roll-to-roll coating, screen printing, spray coating, dip coating or spin coating.

The organic electroluminescent device of the present invention can be used in a display or lighting system selected from flat panel displays, flexible displays, monochromatic flat panel lighting systems, white flat panel lighting systems, flexible monochromatic lighting systems, and flexible white lighting systems.

The present invention will be explained more specifically with reference to the following examples. However, it will be obvious to those skilled in the art that these examples are in no way intended to limit the scope of the invention.

### Synthesis Example 1. Preparation of Compound 64

### Synthesis Example 1-1. Synthesis of Intermediate A-1

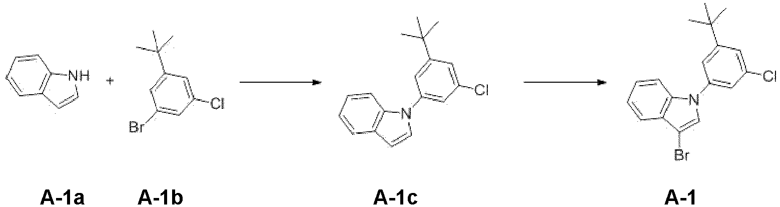

**A-1c** was synthesized using **A-1a** and **A-1b** with reference to the literature (Tetrahedron Letters, 2011, vol. 52, # 11, p. 1161-1164). **A-1** (37.3 g, 83.2%) was synthesized from **A-1c** with reference to the literature (Dyes and Pigments, 2016, vol 133, p. 114-119).
MS (ESI) calcd for Chemical Formula: C₁₈H₁₈ BrClN (Pos)362.03, found 362.0

### Synthesis Example 1-2. Synthesis of Intermediate A-2

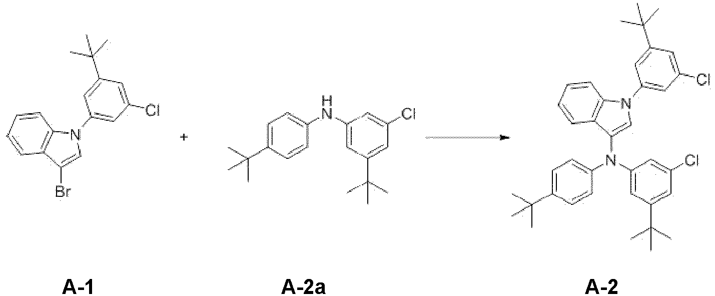

**A-2a** was synthesized with reference to U.S. Patent Publication No. 2020/172558 A1. **A-2** (15.3 g, yield 91.1%) was synthesized from **A-1** and **A-2a** with reference to the literature (Korean Patent Publication No. 2017/52777 A).
MS (ESI) calcd for Chemical Formula: C₃₈H₄₃Cl₂N₂ (Pos)597.28, found 597.2

### Synthesis Example 1-3. Synthesis of Intermediate A-3

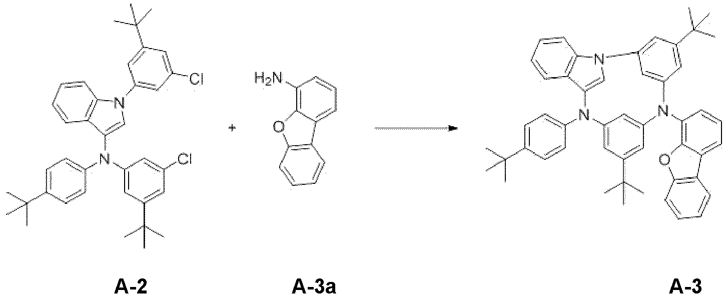

**A-2** (21.7 g), **A-3a** (6.65 g), bis(tri-tert-butylphosphine)palladium(0) (0.56 g), sodium tert-butoxide (10.5 g), and xylene (200 mL) were placed in a reactor. The mixture was stirred under reflux for 24 h. The reaction mixture was cooled to room temperature and water (200 mL) was added thereto. The organic layer was extracted with ethyl acetate, concentrated under reduced pressure, and purified by silica gel column chromatography to afford **A-3** (6.0 g, yield 23.3%).
MS (ESI) calcd for Chemical Formula: C₅ₚH₅₀N₃O (Pos)708.40, found 708.4

### Synthesis Example 1-4. Synthesis of Compound 64

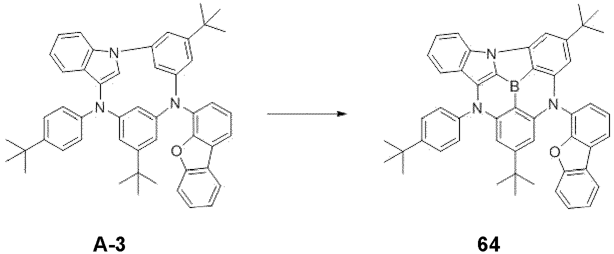

**A-3** (13.6 g) and dichlorobenzene (140 mL) were placed in a reactor and then boron tribromide (1.8 mL) was added dropwise thereto at room temperature. The mixture was stirred under reflux for 16 h. The reaction mixture was cooled to room temperature and water (60 mL) and sodium acetate (4.7 g) were added thereto. The organic layer was extracted with ethyl acetate, concentrated under reduced pressure, and purified by silica gel column chromatography and subsequent recrystallization to give Compound **64** (1.40 g, yield 10.2%).
MS (ESI) calcd for Chemical Formula: C₅₀H₄₇BN₃O (Pos)716.38, found 716.3

### Synthesis Example 2. Synthesis of Compound 65

### Synthesis Example 2-1. Synthesis of Intermediate B-1

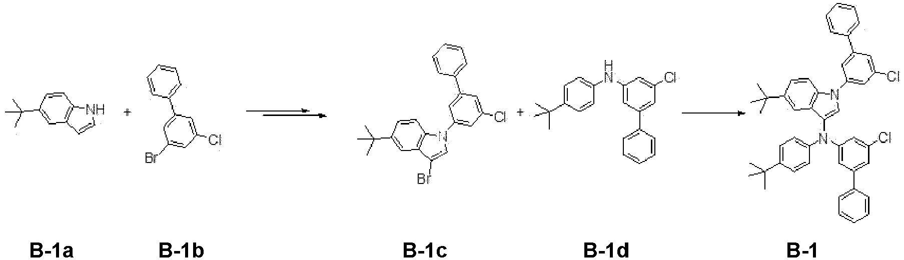

In the same manner as in Synthesis Example 1, Intermediate **B-1c** was synthesized from Intermediate **B-1a** and Intermediate **B-1** (88.1%) was synthesized from Intermediate **B-1c**.
MS (ESI) calcd for Chemical Formula: C₄₆H₄₃Cl₂N₂ (Pos)693.28, found 693.2

### Synthesis Example 2-2. Synthesis of Compound 65

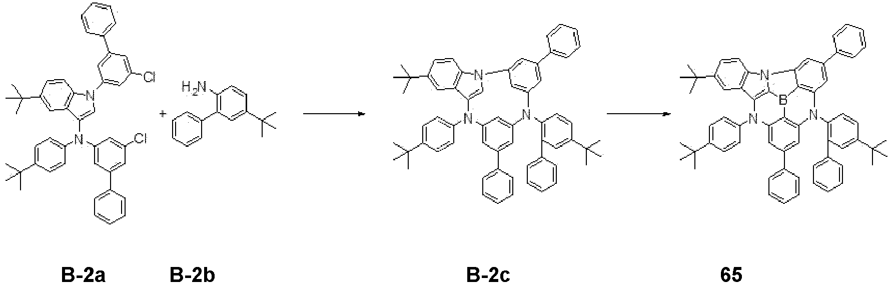

In the same manner as in Synthesis Example 1, Intermediate **B-2c** was synthesized from Intermediate **B-2a** and Compound **65** (9.4%) was synthesized from Intermediate B-2c.
MS (ESI) calcd for Chemical Formula: C₆₂H₅₇BN₃ (Pos)854.47, found 854.4

### Synthesis Example 3. Synthesis of Compound 66

### Synthesis Example 3-1. Synthesis of Intermediate C-1

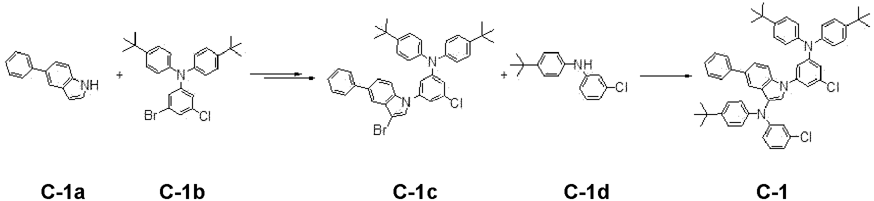

In the same manner as in Synthesis Example 1, Intermediate **C-1c** was synthesized from Intermediate **C-1a** and Intermediate **C-1** (90.1%) was synthesized from Intermediate C-1c.
MS (ESI) calcd for Chemical Formula: C₅₆H₅₆Cl₂N₃ (Pos)840.39, found 840.3

### Synthesis Example 3-2. Synthesis of Compound 66

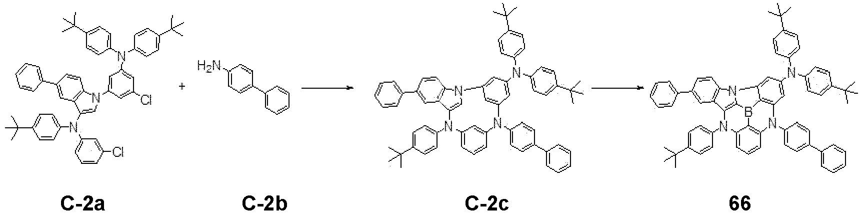

In the same manner as in Synthesis Example 1, Intermediate C-2c was synthesized from Intermediate C-2a and Compound 66 (14.1%) was synthesized from Intermediate C-2c.
MS (ESI) calcd for Chemical Formula: C₆₈H₆₂BN₄ (Pos)945.51, found 945.5

### Synthesis Example 4. Synthesis of Compound 67

### Synthesis Example 4-1. Synthesis of Intermediate D-1

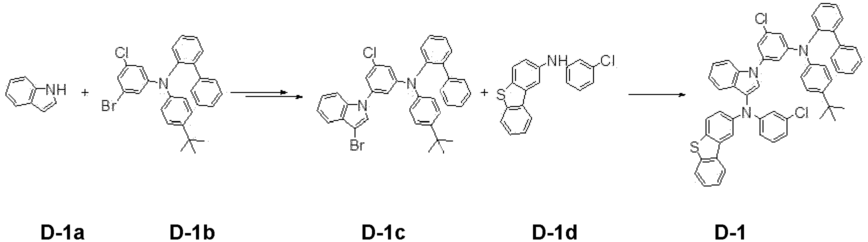

In the same manner as in Synthesis Example 1, Intermediate **D-1c** was synthesized from Intermediate **D-1a** and Intermediate **D-1** (81.2%) was synthesized from Intermediate D-1c.
MS (ESI) calcd for Chemical Formula: C₅₄H₄₂Cl₂N₃O, (Pos)834.25, found 834.2

### Synthesis Example 4-2. Synthesis of Compound 67

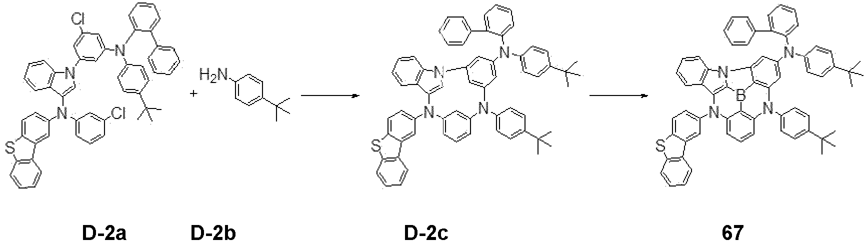

In the same manner as in Synthesis Example 1, Intermediate D-2c was synthesized from Intermediate D-2a and Compound 67 (9.3%) was synthesized from Intermediate D-2c.
MS (ESI) calcd for Chemical Formula: C₆₄H₅₂BN₄S (Pos)919.40, found 919.4

### Synthesis Example 5. Synthesis of Compound 68

### Synthesis Example 5-1. Synthesis of Intermediate E-1

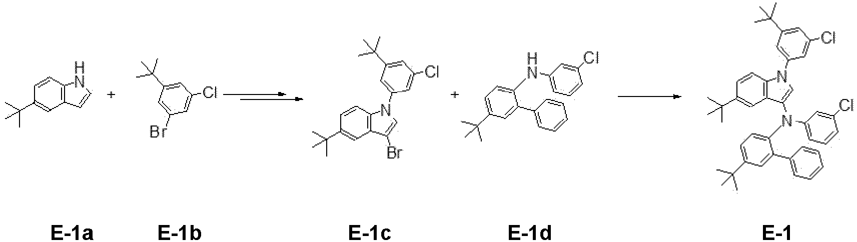

In the same manner as in Synthesis Example 1, Intermediate **E-1c** was synthesized from Intermediate **E-1a** and Intermediate **E-1** (76.5%) was synthesized from Intermediate E-1c.
MS (ESI) calcd for Chemical Formula: C₄₄H₄₇Cl₂N₂ (Pos)673.31, found 673.3

### Synthesis Example 5-2. Synthesis of Compound 68

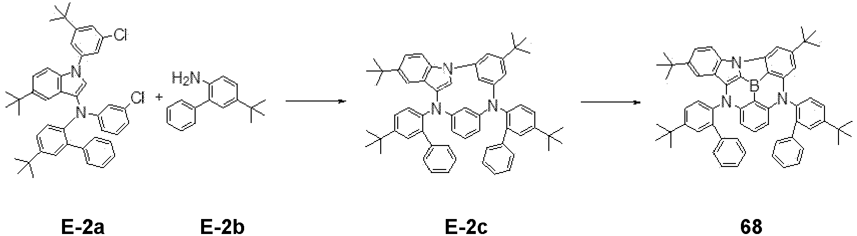

In the same manner as in Synthesis Example 1, Intermediate **E-2c** was synthesized from Intermediate **E-2a** and Compound **68** (8.9%) was synthesized from Intermediate E-2c.
MS (ESI) calcd for Chemical Formula: C₆₀H₆₁BN₃ (Pos)834.50, found 834.5

### Synthesis Example 6. Synthesis of Compound 69

### Synthesis Example 6-1. Synthesis of Intermediate F-1

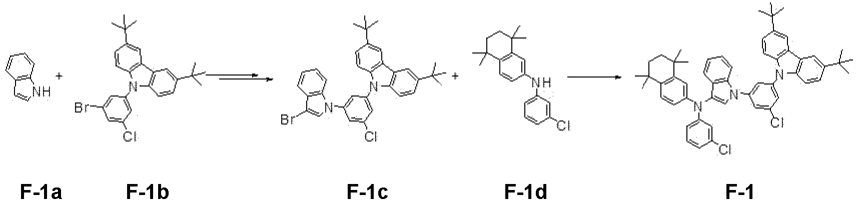

In the same manner as in Synthesis Example 1, Intermediate **F-1c** was synthesized from Intermediate **F-1a** and Intermediate **F-1** (72.4%) was synthesized from Intermediate F-1c.
MS (ESI) calcd for Chemical Formula: C₅₄H₅₆Cl₂N₃ (Pos)816.39, found 816.3

### Synthesis Example 6-2. Synthesis of Compound 69

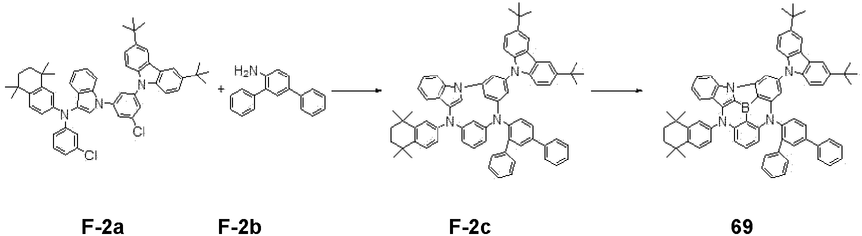

In the same manner as in Synthesis Example 1, Intermediate **F-2c** was synthesized from Intermediate **F-2a** and Compound **69** (8.5%) was synthesized from Intermediate F-2c.
MS (ESI) calcd for Chemical Formula: C₇₂H₆₆BN₄ (Pos)997.54, found 997.5

### Examples 1-10: Fabrication of organic electroluminescent devices

ITO glass was patterned to have a light emitting area of 2 mm × 2 mm, followed by cleaning. After the cleaned ITO glass was mounted in a vacuum chamber, the base pressure was adjusted to 133 x 10⁻⁷ Pa (1 × 10⁻⁷ torr). DNTPD (700 Å) and the compound represented by Formula H (250 Å) were deposited in this order on the ITO. A mixture of the compound represented by BH1 as a host and the inventive compound (3 wt%) shown in Table 1 was used to form a 250 Å thick light emitting layer. Thereafter, a mixture of the compound represented by Formula E-1 and the compound represented by Formula E-2 in a ratio of 1:1 was used to form a 300 Å thick electron transport layer on the light emitting layer. The compound represented by Formula E-1 was used to form a 5 Å thick electron injecting layer on the electron transport layer. Al was used to form a 1000 Å thick Al electrode on the electron injecting layer, completing the fabrication of an organic electroluminescent device. The luminescent properties of the organic electroluminescent device were measured at 0.4 mA.

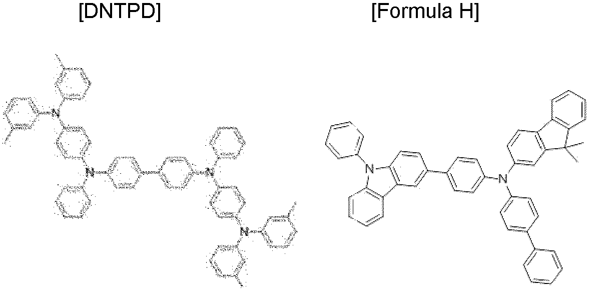

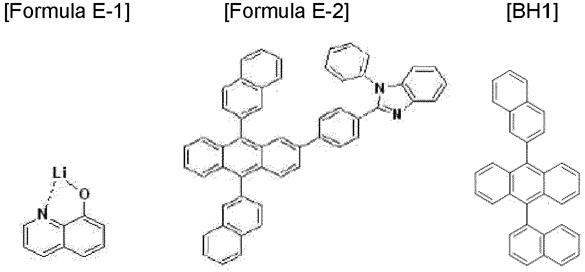

### Comparative Example 1

An organic electroluminescent device was fabricated in the same manner as in Examples 1, except that BD1 was used instead of the inventive compound. The luminescent properties of the organic electroluminescent device were measured at 0.4 mA.

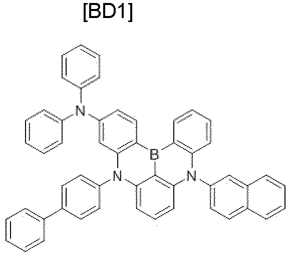

The organic electroluminescent devices of Examples 1-10 and Comparative Example 1 were measured for external quantum efficiency and lifetime. The results are shown in Table 1.

**[Table 1]**

| Example No. | Host | Dopant | External quantum efficiency (%) | T90 (hr) |
|---|---|---|---|---|
| Example 1 | BH1 | Compound 7 | 8.1 | 154 |
| Example 2 | BH1 | Compound 11 | 8.0 | 160 |
| Example 3 | BH1 | Compound 18 | 8.3 | 150 |
| Example 4 | BH1 | Compound 23 | 8.2 | 157 |
| Example 5 | BH1 | Compound 64 | 8.2 | 180 |
| Example 6 | BH1 | Compound 65 | 8.3 | 140 |
| Example 7 | BH1 | Compound 66 | 8.1 | 155 |
| Example 8 | BH1 | Compound 67 | 8.1 | 152 |
| Example 9 | BH1 | Compound 68 | 8.0 | 149 |
| Example 10 | BH1 | Compound 69 | 8.3 | 160 |
| Comparative Example 1 | BH1 | BD1 | 6.0 | 90 |

As can be seen from the results in Table 1, the organic electroluminescent devices of Examples 1-10, each of which employed the inventive compound, showed higher luminous efficiencies and longer lifetimes than the organic electroluminescent of Comparative Example 1.

### Industrial Applicability

The polycyclic aromatic derivative of the present invention can be used to fabricate a highly efficient and long-lasting organic electroluminescent device with significantly improved luminous efficiency. Therefore, the polycyclic aromatic derivative of the present invention can find useful industrial applications in various displays, including flat panel displays and flexible displays, and lighting systems, including monochromatic flat panel lighting systems, white flat panel lighting systems, flexible monochromatic lighting systems, and flexible white lighting systems.

## Claims

1. An organic compound represented by Formula A: 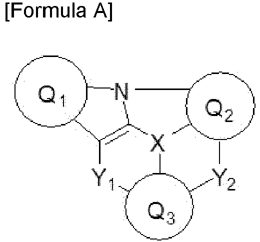 wherein Q₁ is selected from substituted or unsubstituted C₆-C₅₀ monocyclic or polycyclic aromatic hydrocarbon rings, substituted or unsubstituted C₂-C₅₀ monocyclic or polycyclic aromatic heterocyclic rings, substituted or unsubstituted C₆-C₅₀ monocyclic or polycyclic aliphatic hydrocarbon rings, and substituted or unsubstituted C₂-C₅₀ monocyclic or polycyclic aliphatic heterocyclic rings, Q₂ and Q₃ are the same as or different from each other and are each independently selected from substituted or unsubstituted C₆-C₅₀ monocyclic or polycyclic aromatic hydrocarbon rings and substituted or unsubstituted C₂-C₅₀ monocyclic or polycyclic aromatic heterocyclic rings, X is B, Y₁ and Y₂ are the same as or different from each other and are each independently a single bond or selected from 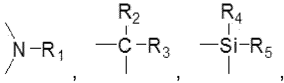 -O-, -S-, and -Se-, and R₁ to R₅ are the same as or different from each other and are each independently selected from hydrogen, deuterium, substituted or unsubstituted C₁-C₃₀ alkyl, substituted or unsubstituted C₁-C₃₀ alkenyl, substituted or unsubstituted C₆-C₅₀ aryl, substituted or unsubstituted C₃-C₃₀ cycloalkyl, substituted or unsubstituted C₂-C₃₀ heterocycloalkyl, substituted or unsubstituted C₂-C₅₀ heteroaryl, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₅-C₃₀ arylthioxy, substituted or unsubstituted amine, substituted or unsubstituted silyl, nitro, cyano, and halogen, with the proviso that each of R₁ to R₅ is optionally bonded to at least one of the rings Q₁ to Q₃ to form an alicyclic or aromatic monocyclic or polycyclic ring, R₂ and R₃ are optionally linked to each other to form an alicyclic or aromatic monocyclic or polycyclic ring, and R₄ and R₅ are optionally linked to each other to form an alicyclic or aromatic monocyclic or polycyclic ring.

2. The organic compound according to claim 1, wherein the organic compound is selected from the following compounds:

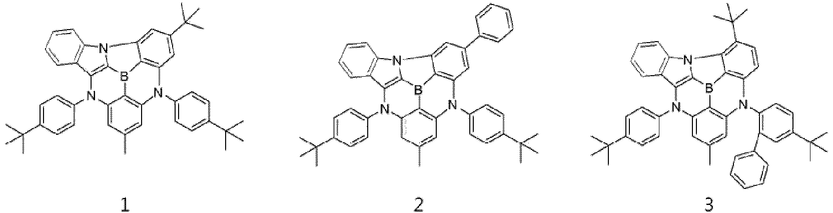

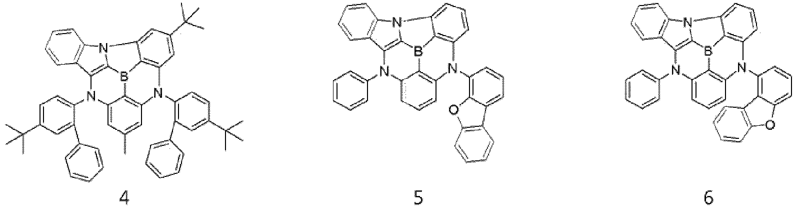

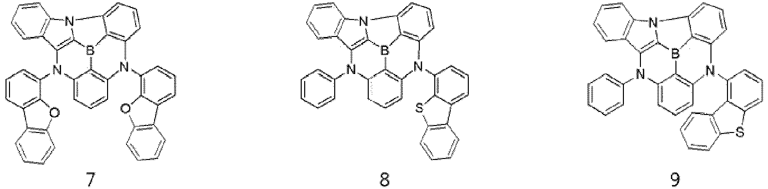

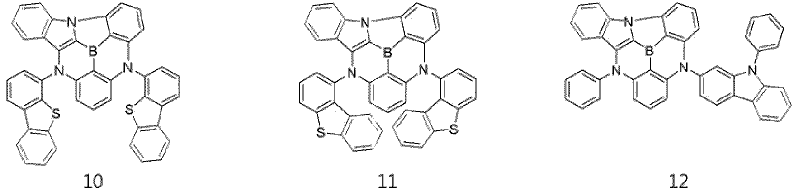

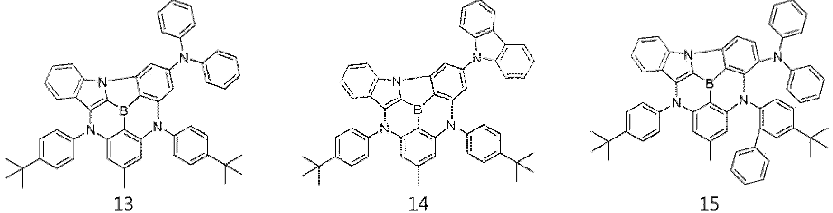

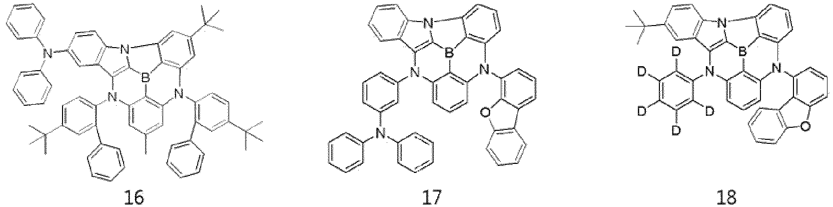

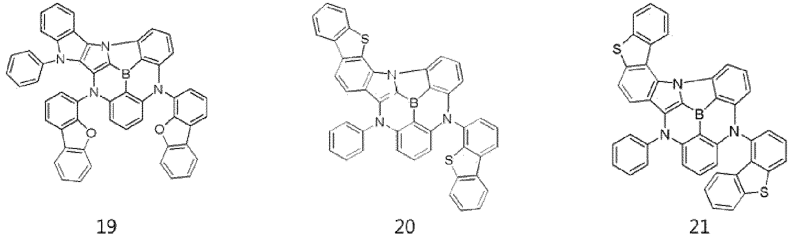

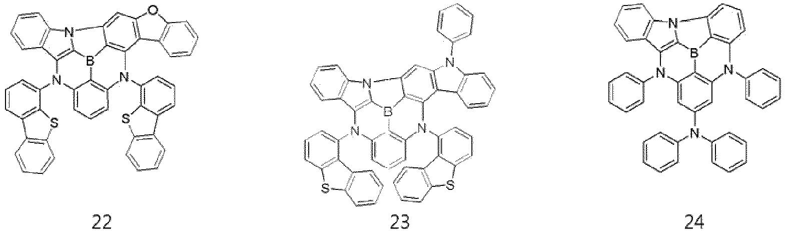

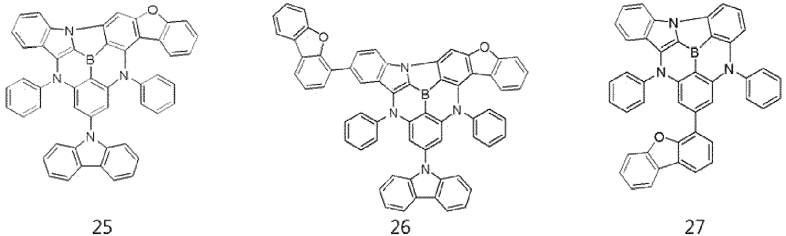

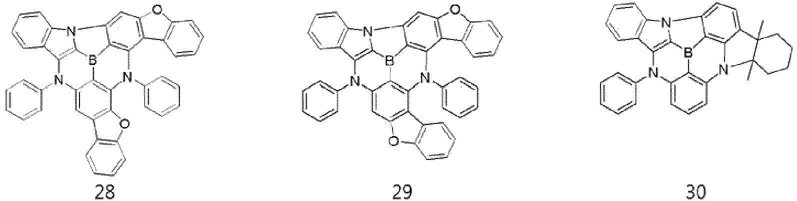

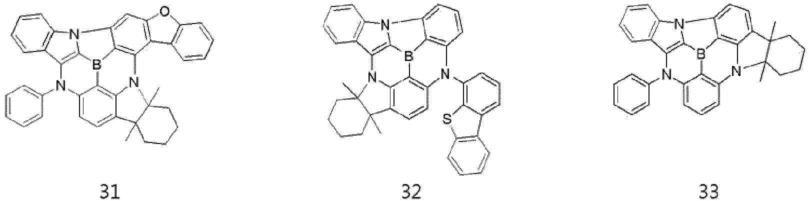

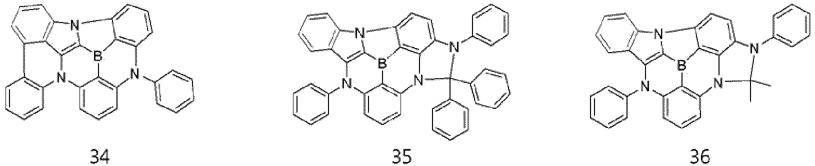

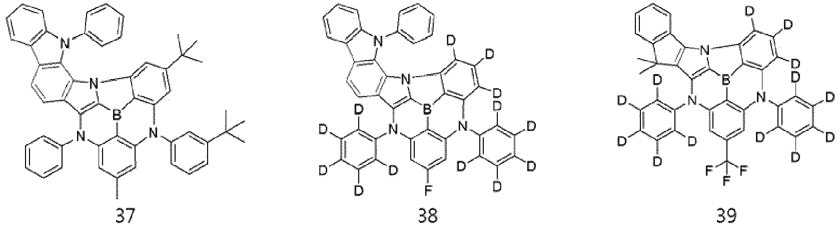

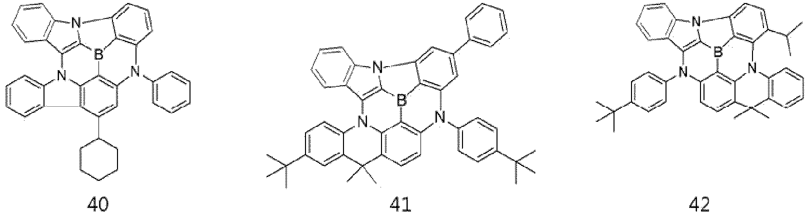

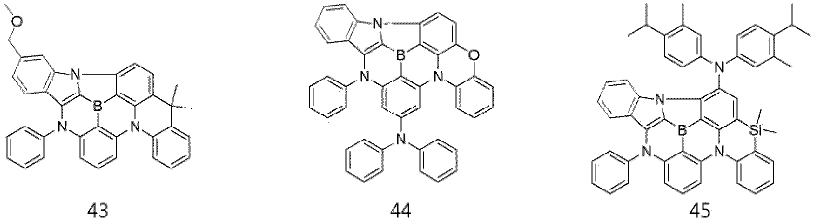

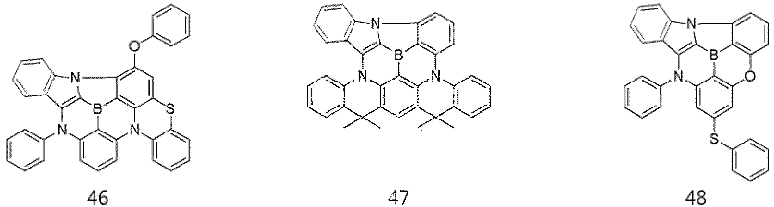

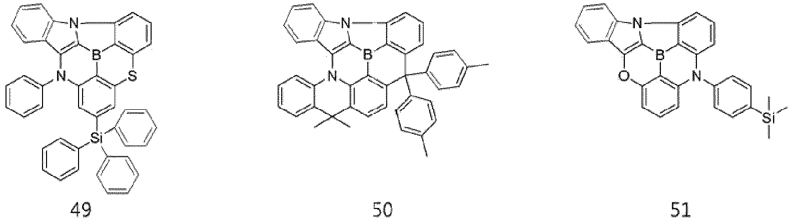

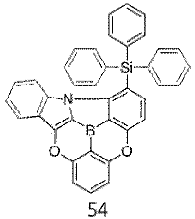

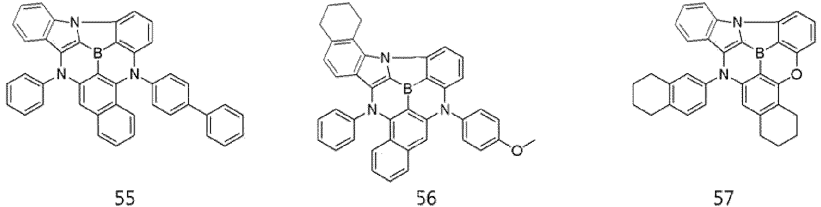

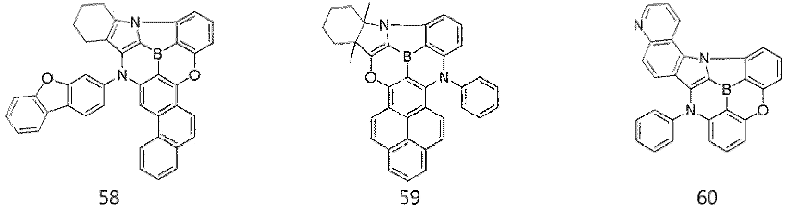

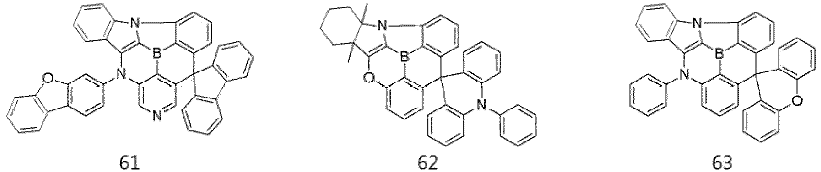

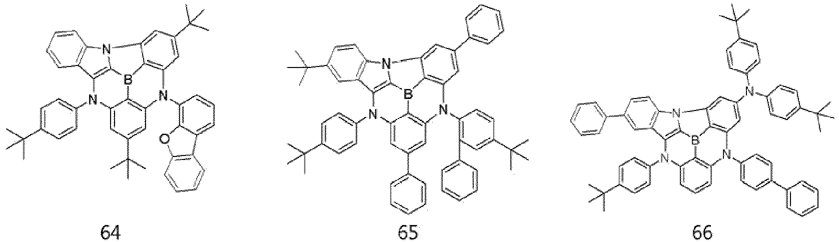

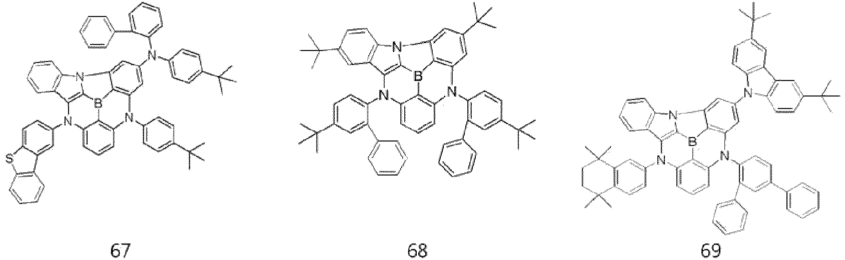

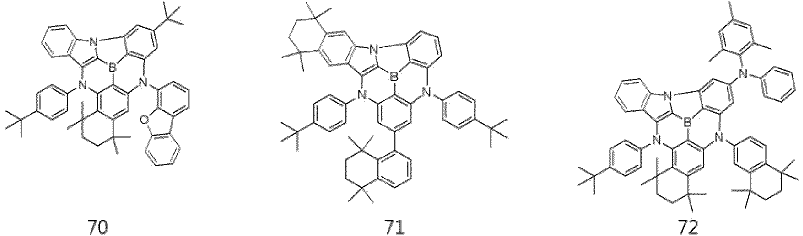

3. An organic electroluminescent device comprising a first electrode, a second electrode, and one or more organic layers interposed between the first and second electrodes wherein one of the organic layers comprises the organic compound represented by Formula A according to claim 1.

4. The organic electroluminescent device according to claim 3, wherein the organic layers comprise an electron injecting layer, an electron transport layer, a hole injecting layer, a hole transport layer, an electron blocking layer, a hole blocking layer, and/or a light emitting layer, at least one of which comprises the organic compound represented by Formula A.

5. The organic electroluminescent device according to claim 4, wherein the light emitting layer is composed of a host and the compound represented by Formula A as a dopant.

6. The organic electroluminescent device according to claim 5, wherein the host is an anthracene derivative represented by Formula C: 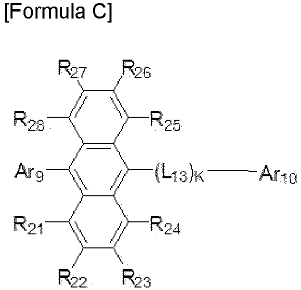 wherein R₂₁ to R₂₈ are identical to or different from each other and are as defined for R in Formula A, Ar₉ and Ar₁₀ are identical to or different from each other and are each independently selected from hydrogen, deuterium, substituted or unsubstituted C₁-C₃₀ alkyl, substituted or unsubstituted C₆-C₅₀ aryl, substituted or unsubstituted C₂-C₃₀ alkenyl, substituted or unsubstituted C₂-C₂₀ alkynyl, substituted or unsubstituted C₃-C₃₀ cycloalkyl, substituted or unsubstituted C₅-C₃₀ cycloalkenyl, substituted or unsubstituted C₂-C₅₀ heteroaryl, substituted or unsubstituted C₂-C₃₀ heterocycloalkyl, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₆-C₃₀ arylthioxy, halogen, substituted or unsubstituted amine, and substituted or unsubstituted silyl, L₁₃ is a single bond or is selected from substituted or unsubstituted C₆-C₂₀ arylene and substituted or unsubstituted C₂-C₂₀ heteroarylene, and k is an integer from 1 to 3, provided that when k is 2 or more, the linkers L₁₃ are identical to or different from each other.

7. The organic electroluminescent device according to claim 6, wherein Ar₉ in Formula C is a substituted or unsubstituted phenyl group or a substituted or unsubstituted naphthyl group.

8. The organic electroluminescent device according to claim 6, wherein the anthracene derivative represented by Formula C is selected from the compounds of Formulae C1 to C69:

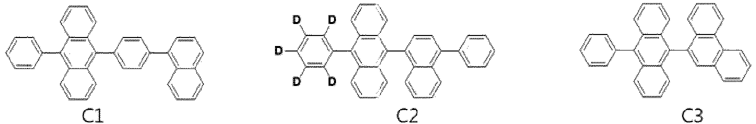

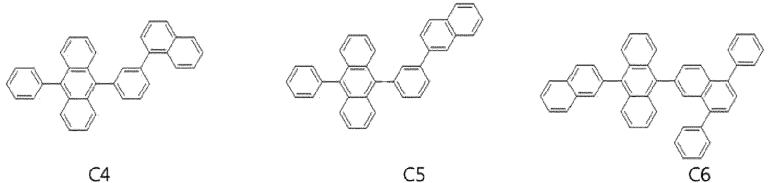

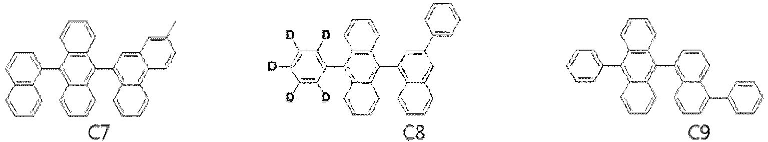

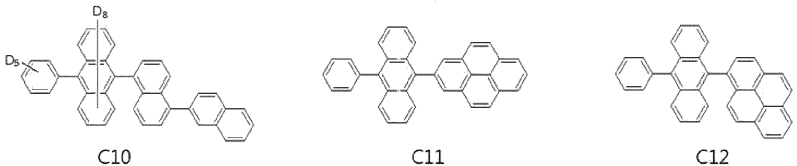

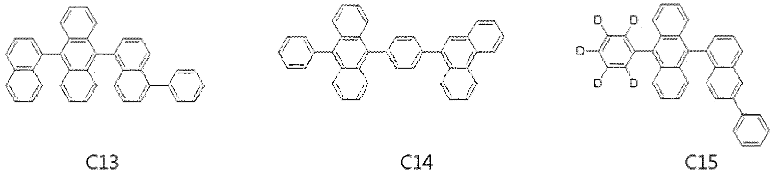

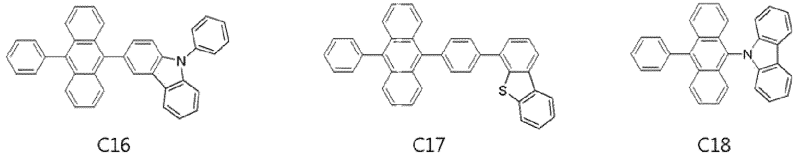

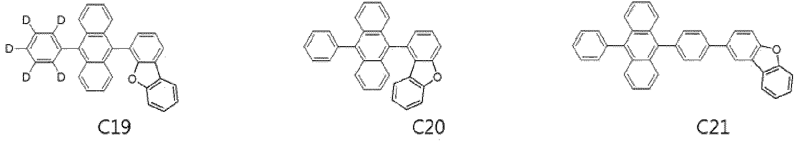

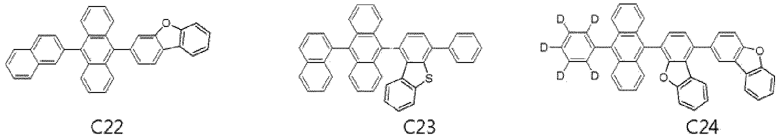

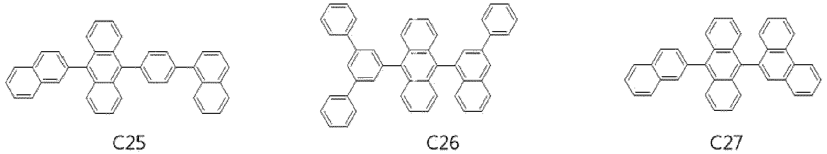

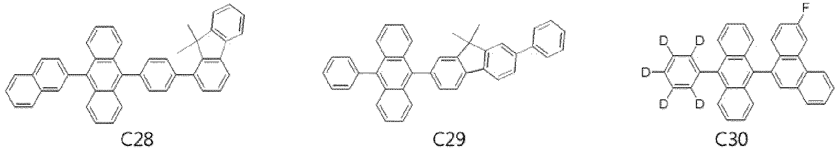

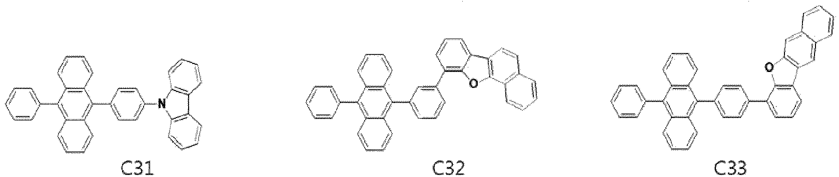

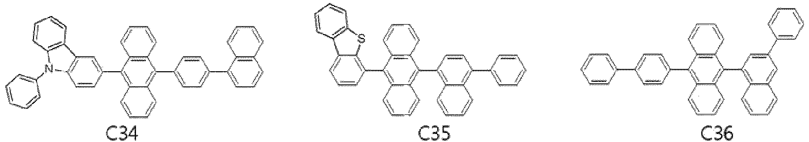

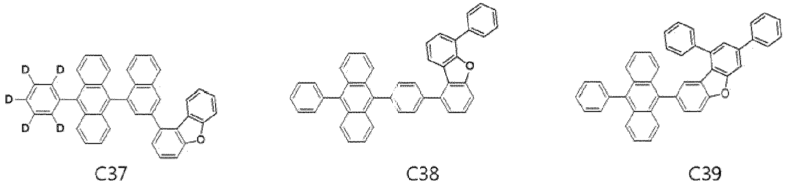

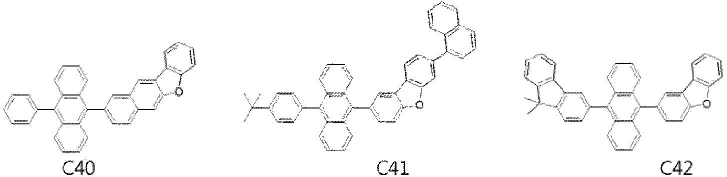

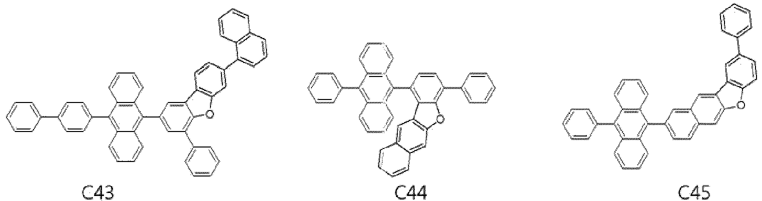

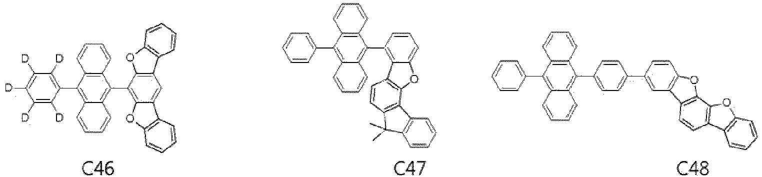

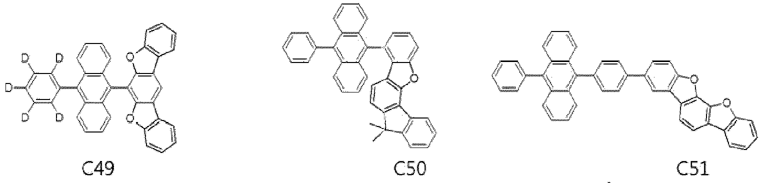

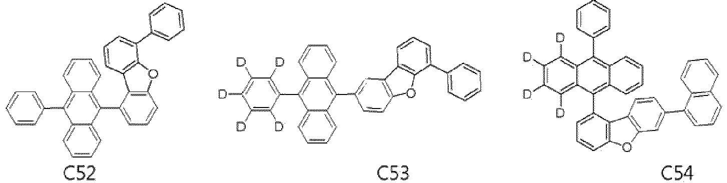

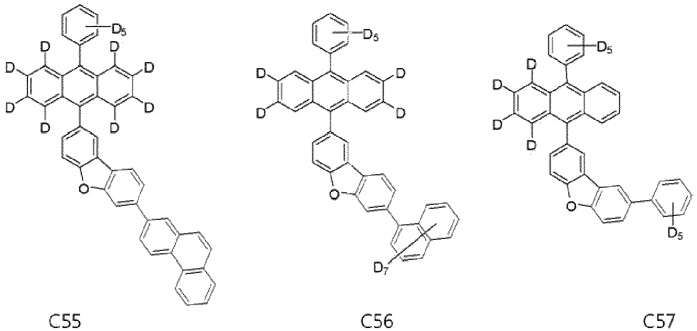

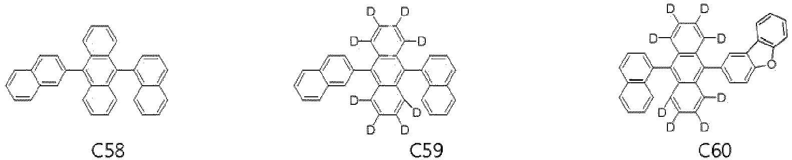

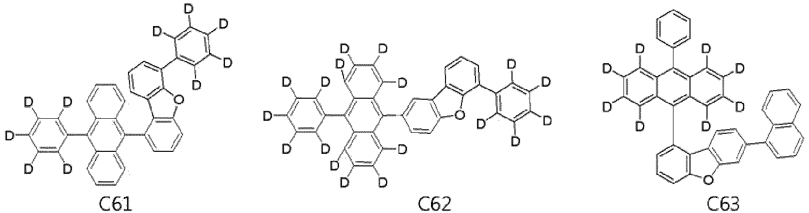

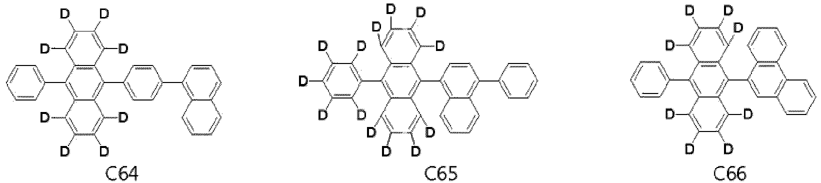

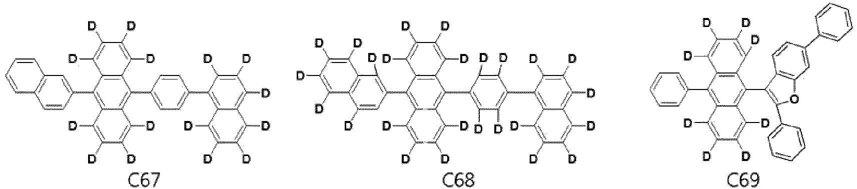

9. The organic electroluminescent device according to claim 4, wherein one or more of the layers are formed by a deposition or solution process.

10. The organic electroluminescent device according to claim 3, wherein the organic electroluminescent device is used in a display or lighting system selected from flat panel displays, flexible displays, monochromatic flat panel lighting systems, white flat panel lighting systems, flexible monochromatic lighting systems, and flexible white lighting systems.

## Patentansprüche

1. Eine organische Verbindung, dargestellt durch Formel A: 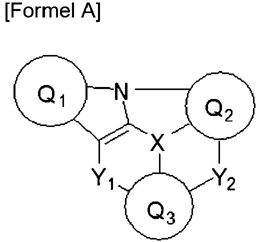 wobei Q₁ ausgewählt ist aus substituierten oder unsubstituierten C₆-C₅₀-monocyclischen oder polycyclischen aromatischen Kohlenwasserstoffringen, substituierten oder unsubstituierten C₂-C₅₀-monocyclischen oder polycyclischen aromatischen heterocyclischen Ringen, substituierten oder unsubstituierten C₆-C₅₀-monocyclischen oder polycyclischen aliphatischen Kohlenwasserstoffringen, und substituierten oder unsubstituierten C₂-C₅₀-monocyclischen oder polycyclischen aliphatischen heterocyclischen Ringen, Q₂ und Q₃ identisch oder voneinander verschieden sind und jeweils unabhängig voneinander ausgewählt sind aus substituierten oder unsubstituierten C₆-C₅₀-monocyclischen oder polycyclischen aromatischen Kohlenwasserstoffringen und substituierten oder unsubstituierten C₂-C₅₀-monocyclischen oder polycyclischen aromatischen heterocyclischen Ringen, X B ist, Y₁ und Y₂ gleich oder voneinander verschieden sind und jeweils unabhängig voneinander eine Einfachbindung sind oder ausgewählt sind aus 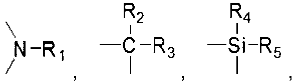 -O-, -S-, und -Se-, und R₁ bis R₅ identisch oder voneinander verschieden sind und jeweils unabhängig voneinander ausgewählt sind aus Wasserstoff, Deuterium, substituiertem oder unsubstituiertem C₁-C₃₀-Alkyl, substituiertem oder unsubstituiertem C₁-C₃₀-Alkenyl, substituiertem oder unsubstituiertem C₆-C₅₀-Aryl, substituiertem oder unsubstituiertem C₃-C₃₀-Cycloalkyl, substituiertem oder unsubstituiertem C₂-C₃₀-Heterocycloalkyl, substituiertem oder unsubstituiertem C₂-C₅₀-Heteroaryl, substituiertem oder unsubstituiertem C₁-C₃₀-Alkoxy, substituiertem oder unsubstituiertem C₆-C₃₀-Aryloxy, substituiertem oder unsubstituiertem C₁-C₃₀-Alkylthioxy, substituiertem oder unsubstituiertem C₅-C₃₀-Arylthioxy, substituiertem oder unsubstituiertem Amin, substituiertem oder unsubstituiertem Silyl, Nitro, Cyano und Halogen, mit der Maßgabe, dass jedes von R₁ bis R₅ optional an mindestens einen der Ringe Q₁ bis Q₃ gebunden ist, um einen alicyclischen oder aromatischen monocyclischen oder polycyclischen Ring zu bilden, R₂ und R₃ optional miteinander verbunden sind, um einen alicyclischen oder aromatischen monocyclischen oder polycyclischen Ring zu bilden, und R₄ und R₅ optional miteinander verbunden sind, um einen alicyclischen oder aromatischen monocyclischen oder polycyclischen Ring zu bilden.

2. Die organische Verbindung gemäß Anspruch 1, wobei die organische Verbindung aus den folgenden Verbindungen ausgewählt ist:

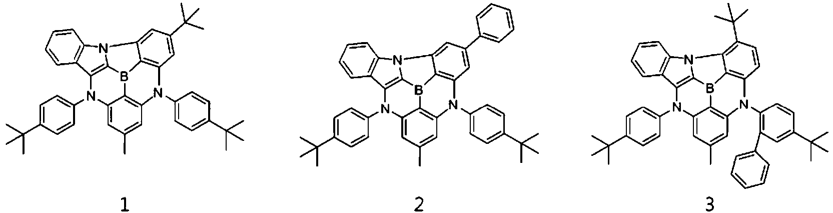

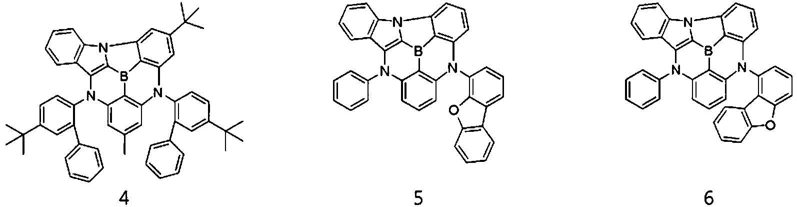

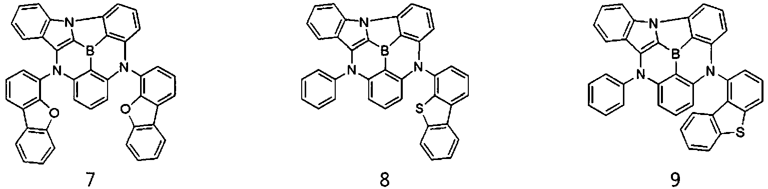

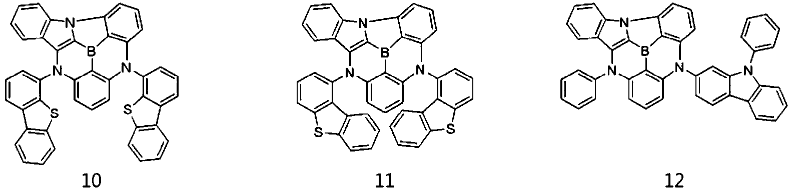

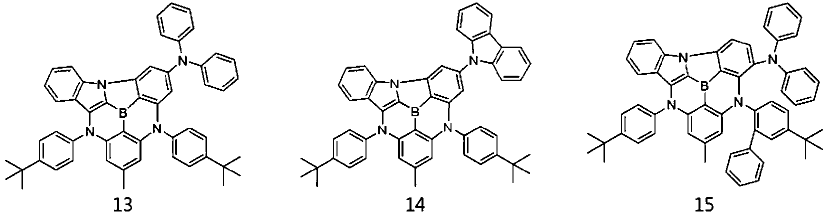

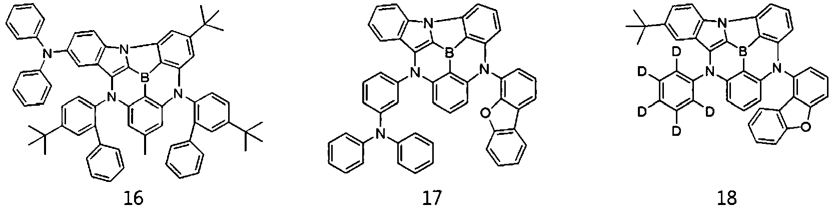

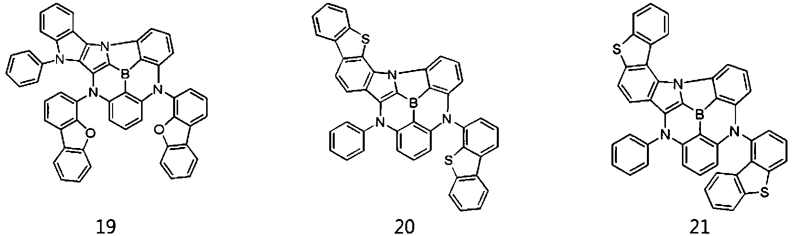

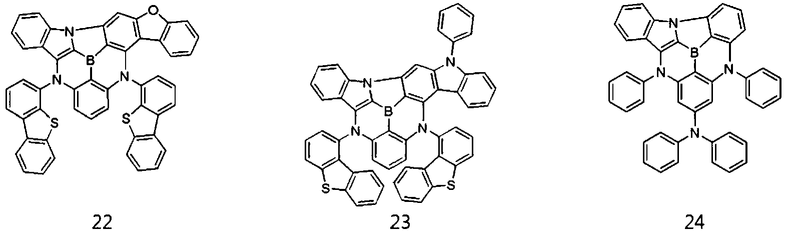

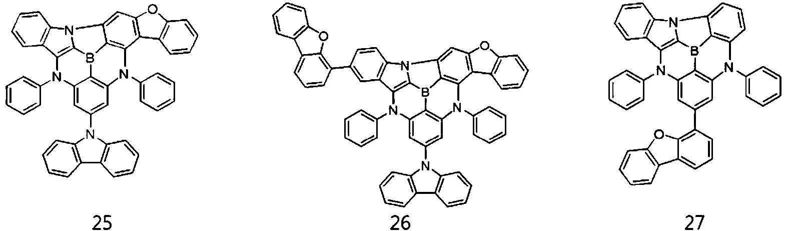

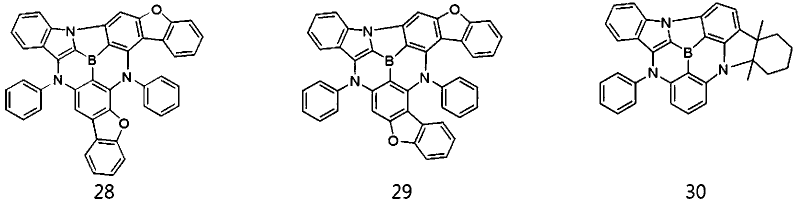

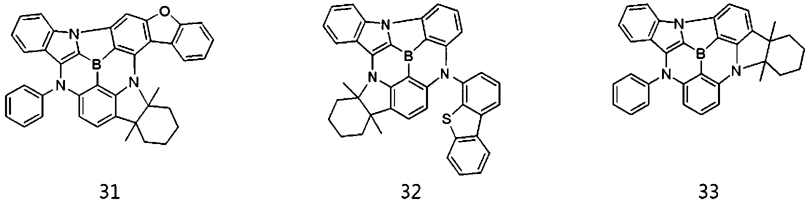

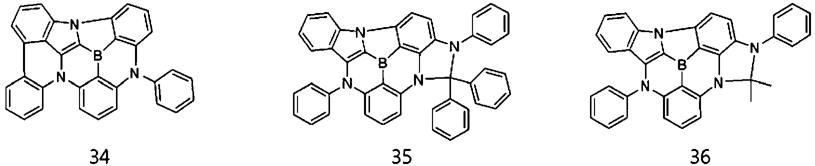

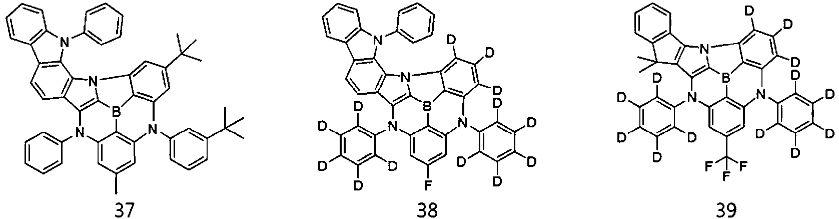

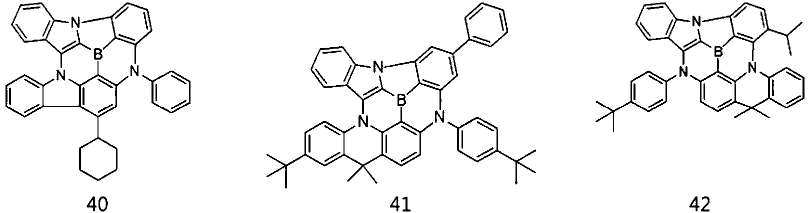

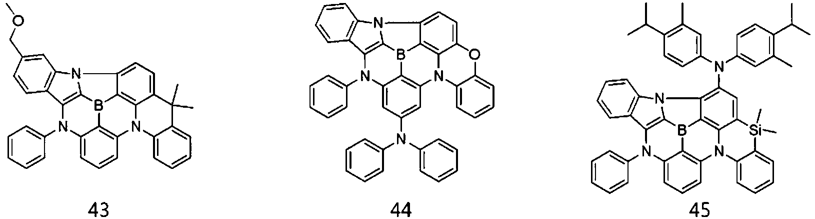

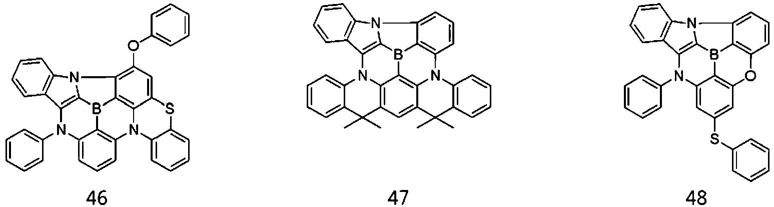

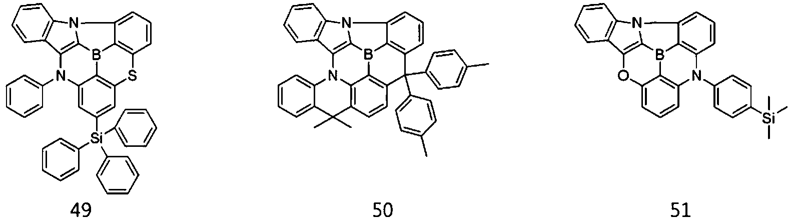

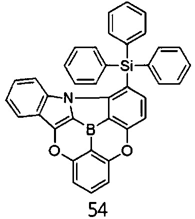

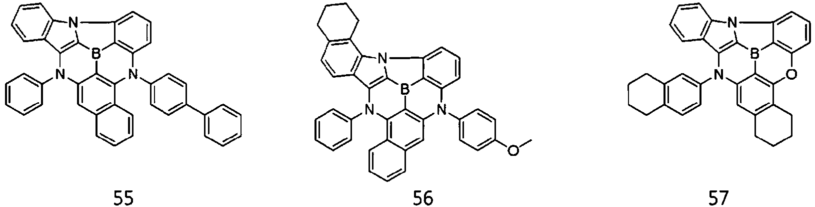

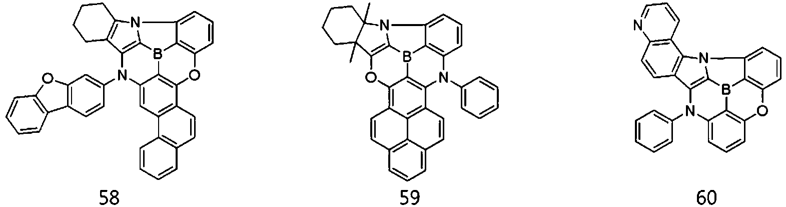

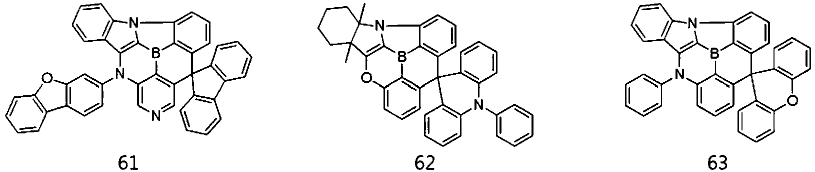

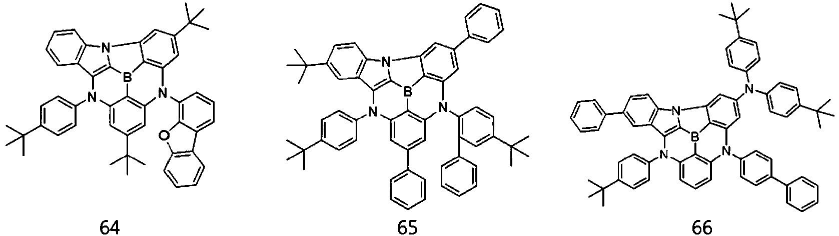

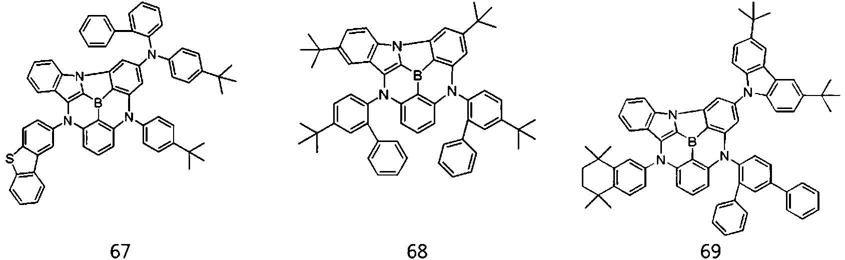

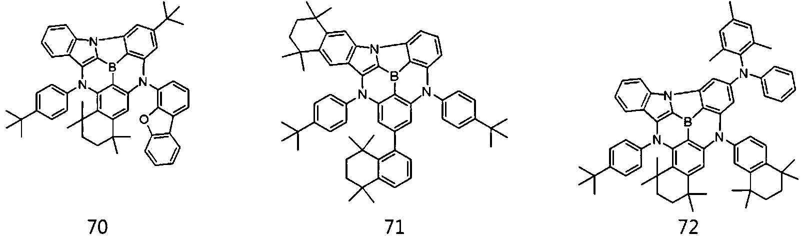

3. Eine organische elektrolumineszente Vorrichtung, die eine erste Elektrode, eine zweite Elektrode und eine oder mehrere organische Schichten umfasst, die zwischen der ersten und der zweiten Elektrode angeordnet sind, wobei eine der organischen Schichten die organische Verbindung umfasst, die durch die Formel A gemäß Anspruch 1 dargestellt ist.

4. Die organische elektrolumineszente Vorrichtung gemäß Anspruch 3, wobei die organischen Schichten eine Elektroneninjektionsschicht, eine Elektronentransportschicht, eine Lochinjektionsschicht, eine Lochtransportschicht, eine Elektronenblockierschicht, eine Lochblockierschicht und/oder eine lichtemittierende Schicht umfassen, von denen mindestens eine die durch Formel A dargestellte organische Verbindung umfasst.

5. Die organische elektrolumineszente Vorrichtung gemäß Anspruch 4, wobei die lichtemittierende Schicht aus einem Wirtsmaterial und der durch Formel A dargestellten Verbindung als Dotierstoff zusammengesetzt ist.

6. Die organische elektrolumineszente Vorrichtung gemäß Anspruch 5, wobei der Wirtsstoff ein Anthracenderivat ist, das durch Formel C dargestellt wird: 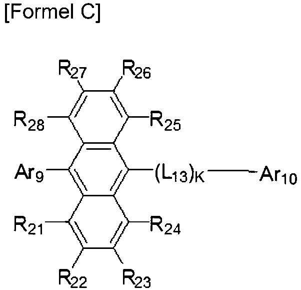 wobei R₂₁ bis R₂₈ identisch oder voneinander verschieden sind und wie für R in Formel A definiert sind, Ar₉ und Ar₁₀ identisch oder voneinander verschieden sind und jeweils unabhängig voneinander ausgewählt sind aus Wasserstoff, Deuterium, substituiertem oder unsubstituiertem C₁-C₃₀-Alkyl, substituiertem oder unsubstituiertem C₆-C₅₀-Aryl, substituiertem oder unsubstituiertem C₂-C₃₀-Alkenyl, substituiertem oder unsubstituiertem C₂-C₂₀-Alkinyl, substituiertem oder unsubstituiertem C₃-C₃₀-Cycloalkyl, substituiertem oder unsubstituiertem C₅-C₃₀-Cycloalkenyl, substituiertem oder unsubstituiertem C₂-C₅₀-Heteroaryl, substituiertem oder unsubstituiertem C₂-C₃₀-Heterocycloalkyl, substituiertem oder unsubstituiertem C₁-C₃₀-Alkoxy, substituiertem oder unsubstituiertem C₆-C₃₀-Aryloxy, substituiertem oder unsubstituiertem C₁-C₃₀-Alkylthioxy, substituiertem oder unsubstituiertem C₆-C₃₀-Arylthioxy, Halogen, substituiertem oder unsubstituiertem Amin und substituiertem oder unsubstituiertem Silyl, L₁₃ eine Einfachbindung ist oder aus substituiertem oder unsubstituiertem C₆-C₂₀-Arylen und substituiertem oder unsubstituiertem C₂-C₂₀-Heteroarylen ausgewählt ist, und k eine ganze Zahl von 1 bis 3 ist, mit der Maßgabe, dass, wenn k 2 oder mehr ist, die Linker L₁₃ identisch oder voneinander verschieden sind.

7. Die organische elektrolumineszente Vorrichtung gemäß Anspruch 6, wobei Ar₉ in Formel C eine substituierte oder unsubstituierte Phenylgruppe oder eine substituierte oder unsubstituierte Naphthylgruppe ist.

8. Die organische elektrolumineszente Vorrichtung gemäß Anspruch 6, wobei das durch Formel C dargestellte Anthracenderivat ausgewählt ist aus den Verbindungen der Formeln C1 bis C69:

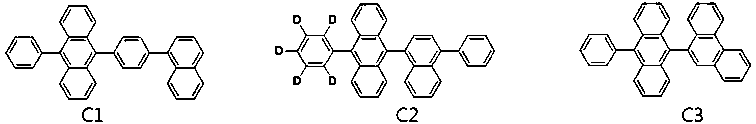

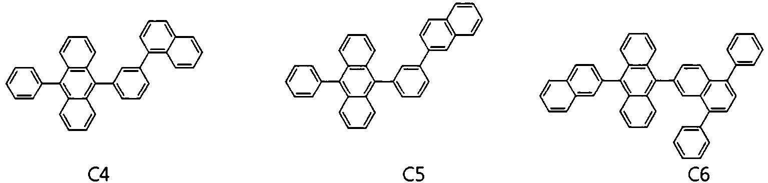

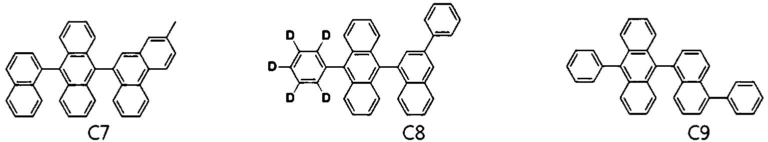

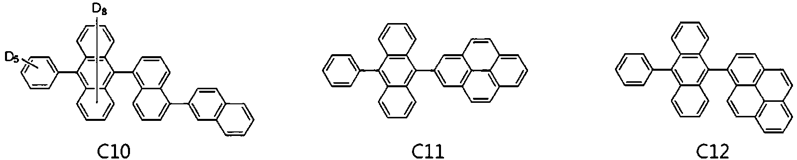

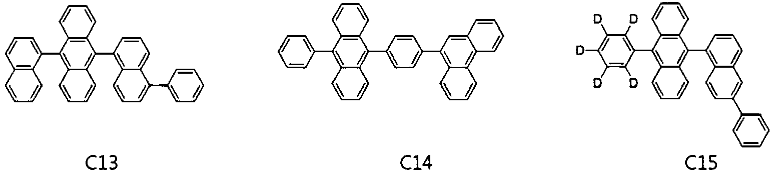

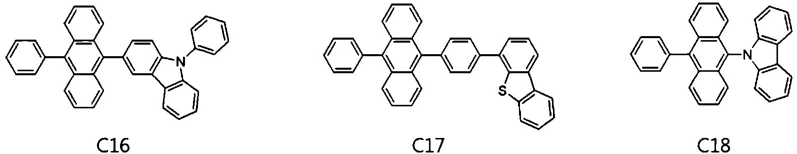

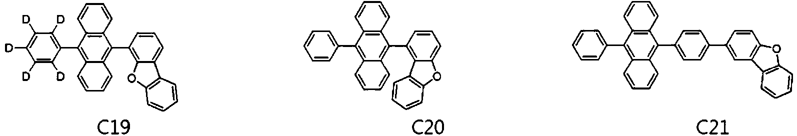

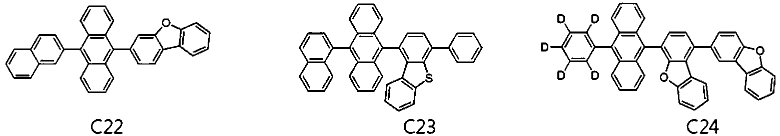

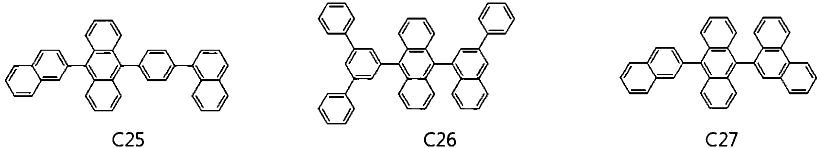

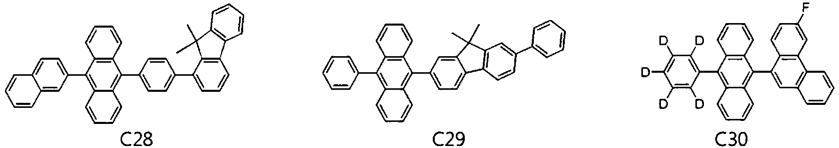

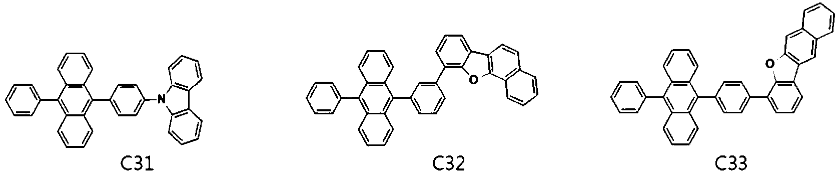

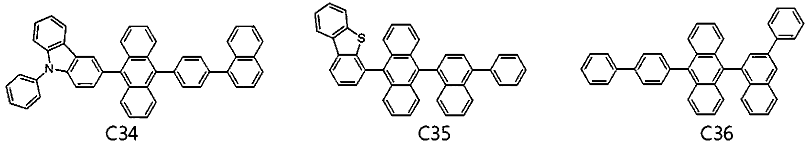

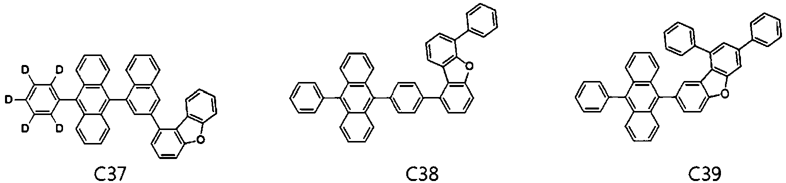

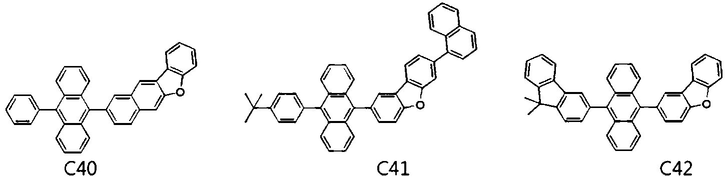

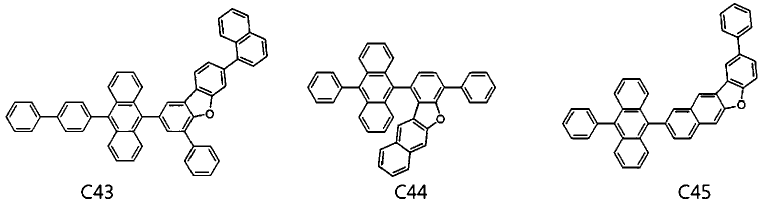

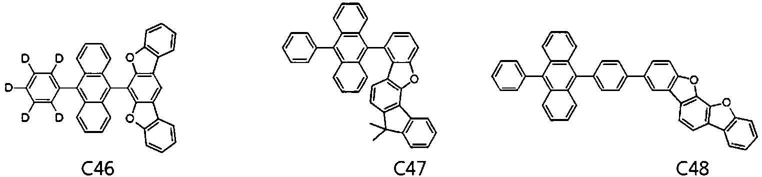

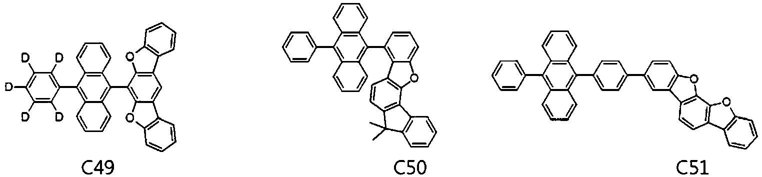

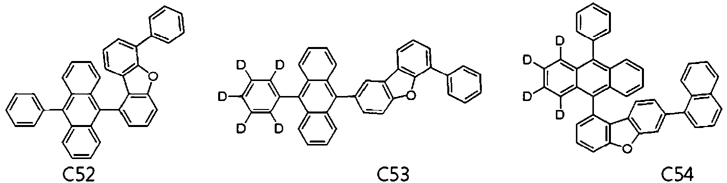

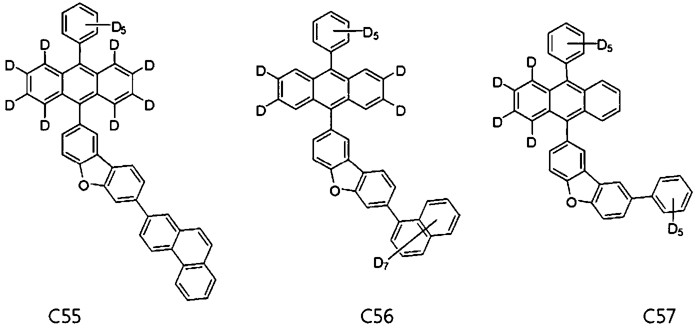

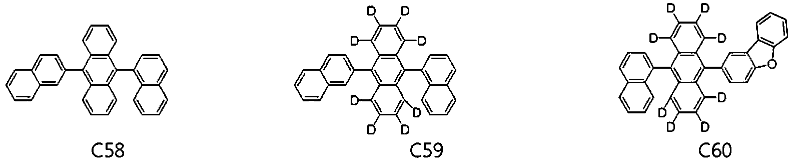

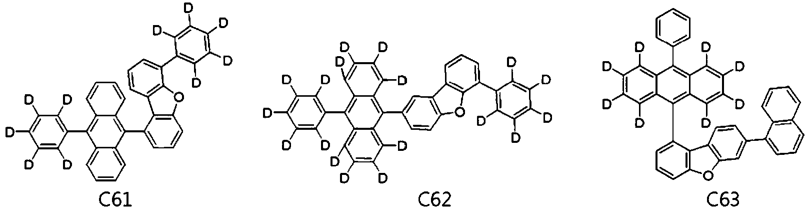

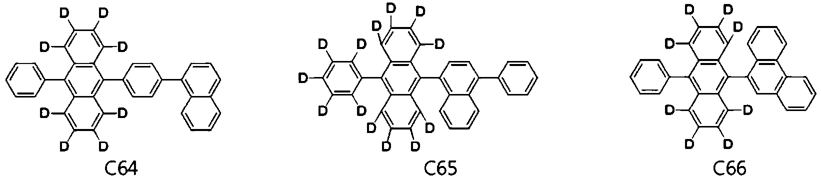

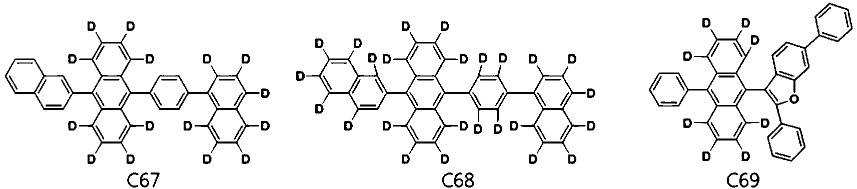

9. Die organische elektrolumineszente Vorrichtung gemäß Anspruch 4, wobei eine oder mehrere der Schichten durch einen Abscheidungs- oder Lösungsprozess gebildet sind.

10. Die organische elektrolumineszente Vorrichtung gemäß Anspruch 3, wobei die organische elektrolumineszente Vorrichtung in einem Anzeigegerät oder Beleuchtungssystem verwendet wird, das aus Flachbildschirmen, flexiblen Anzeigegeräten, monochromatischen Flachbildschirm-Beleuchtungssystemen, weißen Flachbildschirm-Beleuchtungssystemen, flexiblen monochromatischen Beleuchtungssystemen und flexiblen weißen Beleuchtungssystemen ausgewählt ist.

## Revendications

1. Composé organique représenté par la Formule A : 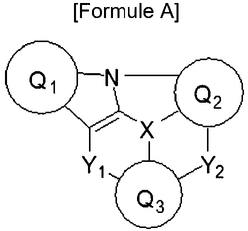 Q, étant choisi parmi des cycles hydrocarbonés aromatiques monocycliques ou polycycliques en C₆-C₅₀ substitués ou non substitués, des cycles hétérocycliques aromatiques monocycliques ou polycycliques en C₂-C₅₀ substitués ou non substitués, des cycles hydrocarbonés aliphatiques monocycliques ou polycycliques C₆-C₅₀ substitués ou non substitués, et des cycles hétérocycliques aliphatiques monocycliques ou polycycliques C₂-C₅₀ substitués ou non substitués, Q₂ et Q₃ étant identiques ou différents les uns des autres et étant chacun indépendamment choisis parmi des cycles hydrocarbonés aromatiques monocycliques ou polycycliques en C₆-C₅₀ substitués ou non substitués et des cycles hétérocycliques aromatiques monocycliques ou polycycliques en C₂-C₅₀ substitués ou non substitués, X étant B, Y₁ et Y₂ étant identiques ou différents les uns des autres et étant chacun indépendamment une liaison simple ou choisis parmi 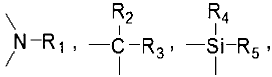 -O-, -S-, et -Se-, et R₁ à R₅ étant identiques ou différents les uns des autres et étant chacun indépendamment choisis parmi hydrogène, deutérium, alkyle en C₁-C₃₀ substitué ou non substitué, alcényle en C₁-C₃₀ substitué ou non substitué, aryle en C₆-C₅₀ substitué ou non substitué, cycloalkyle en C₃-C₃₀ substitué ou non substitué, hétérocycloalkyle en C₂-C₃₀ substitué ou non substitué, hétéroaryle en C₂-C₅₀ substitué ou non substitué, alcoxy en C₁-C₃₀ substitué ou non substitué, aryloxy en C₆-C₃₀ substitué ou non substitué, alkylthioxy en C₁-C₃₀ substitué ou non substitué, arylthioxy en C₅-C₃₀ substitué ou non substitué, amine substituée ou non substituée, silyle substitué ou non substitué, nitro, cyano, et halogène, sous réserve que chacun des R₁ à R₅ est optionnellement lié à au moins un des cycles Q₁ à Q₃ pour former un monocycle ou polycycle alicyclique ou aromatique, R₂ et R₃ sont optionnellement reliés l'un à l'autre pour former un monocycle ou polycycle alicyclique ou aromatique, et R₄ et R₅ sont optionnellement reliés l'un à l'autre pour former un monocycle ou polycycle alicyclique ou aromatique.

2. Composé organique selon la revendication 1, dans lequel le composé organique est choisi parmi les composés suivants :

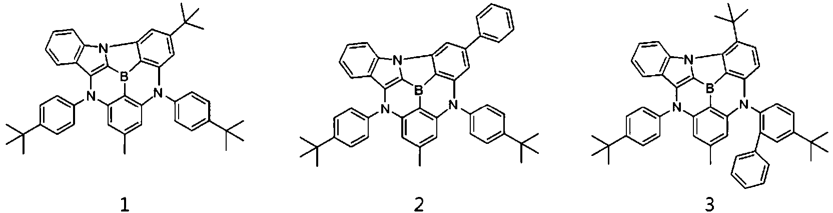

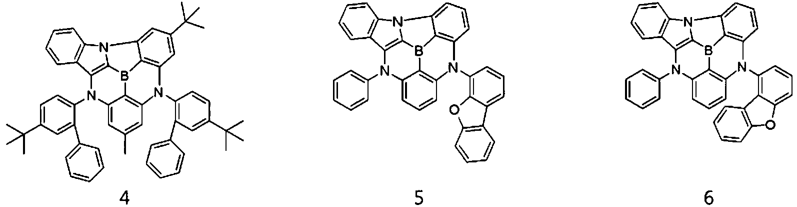

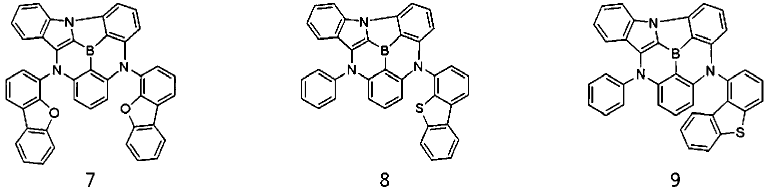

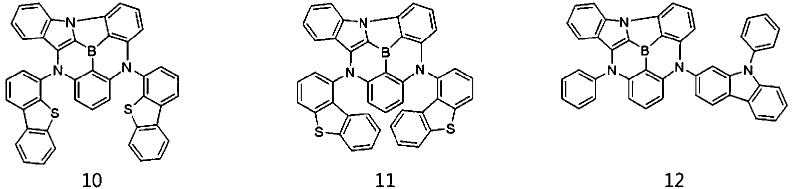

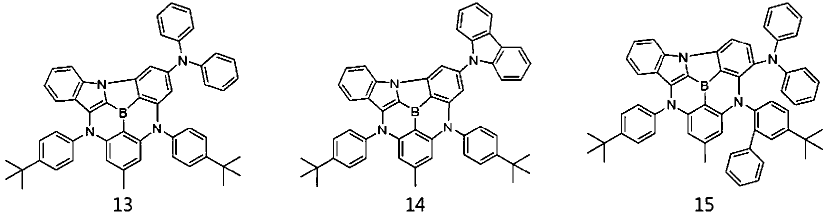

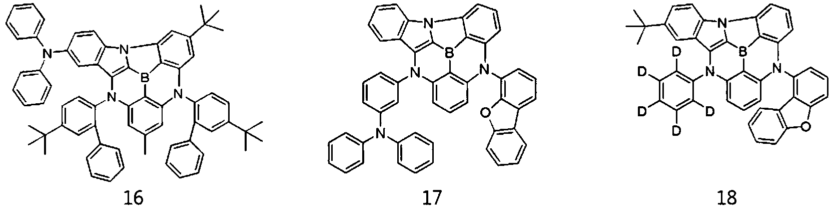

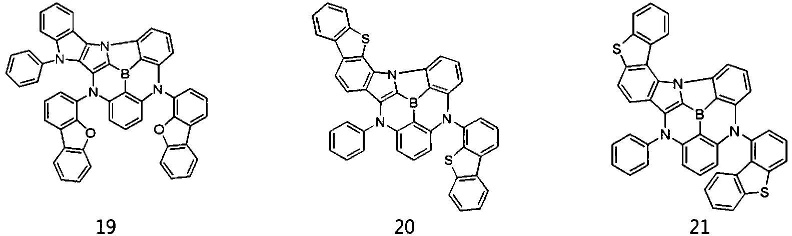

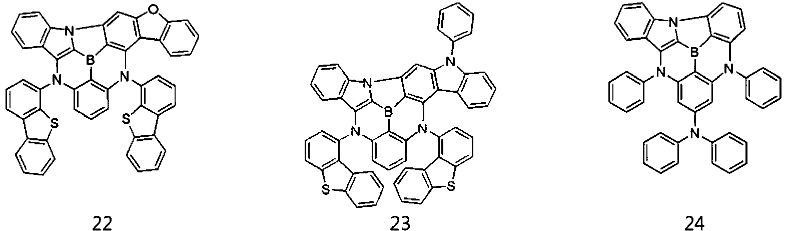

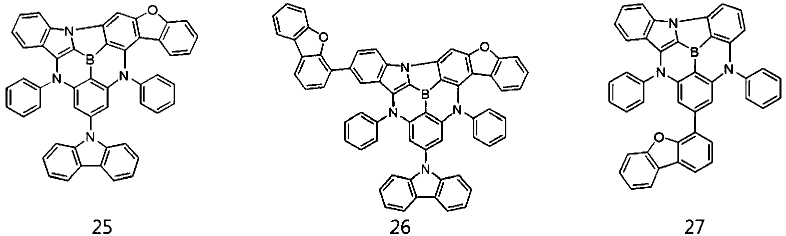

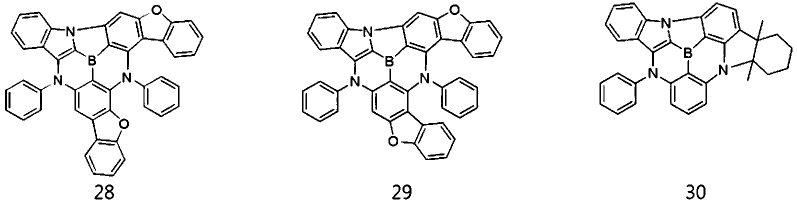

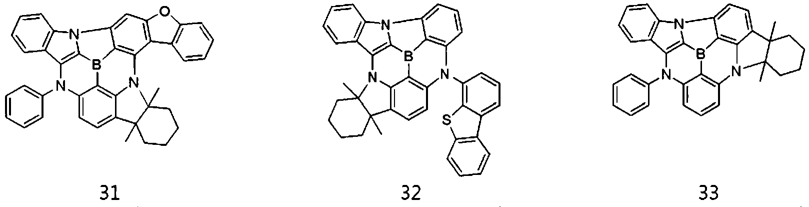

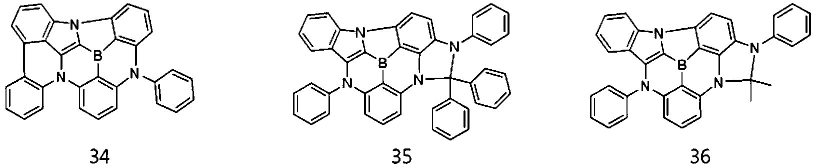

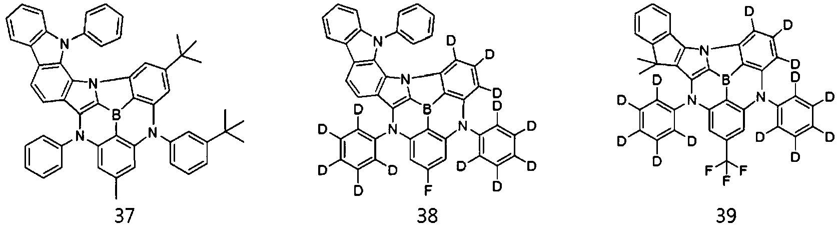

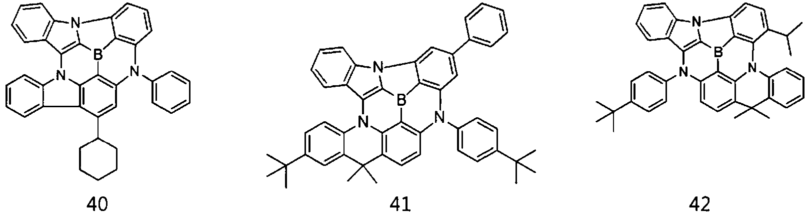

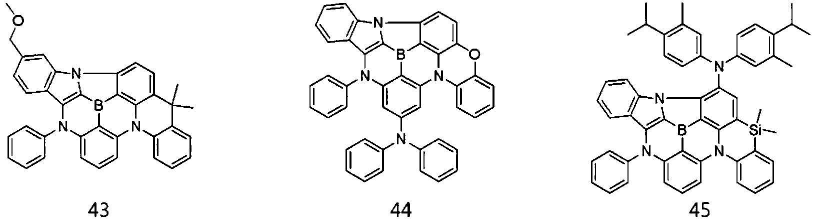

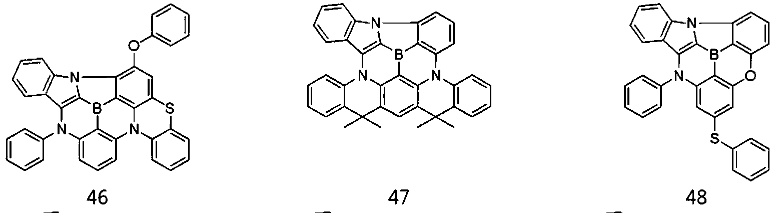

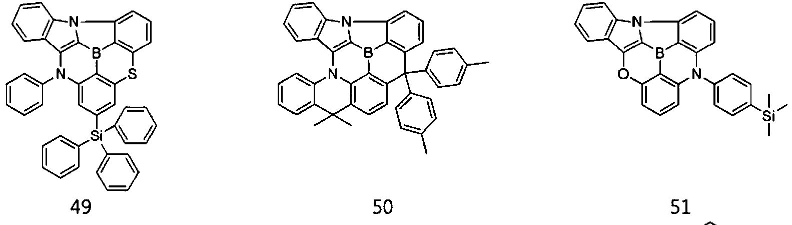

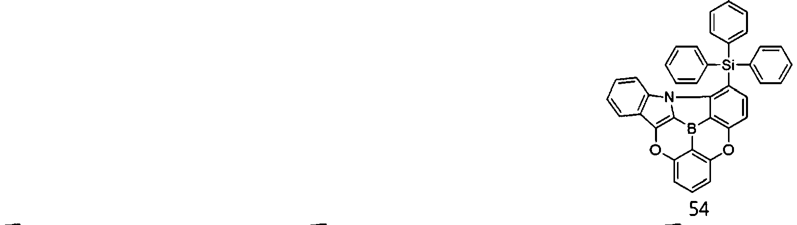

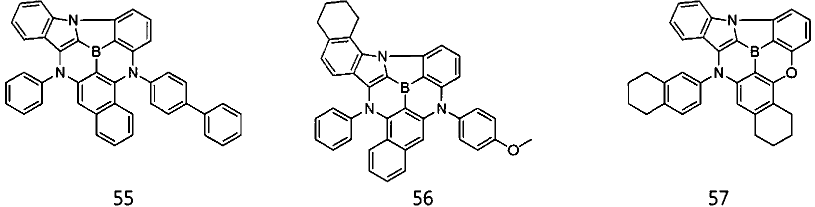

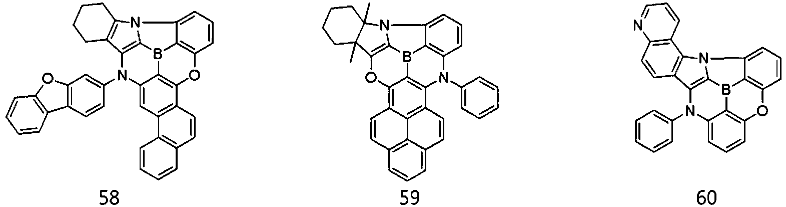

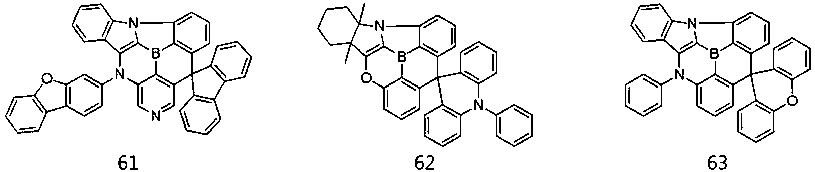

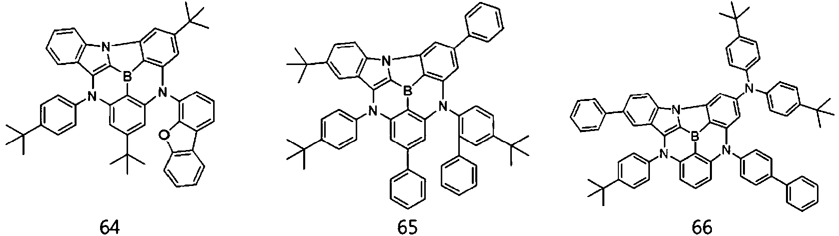

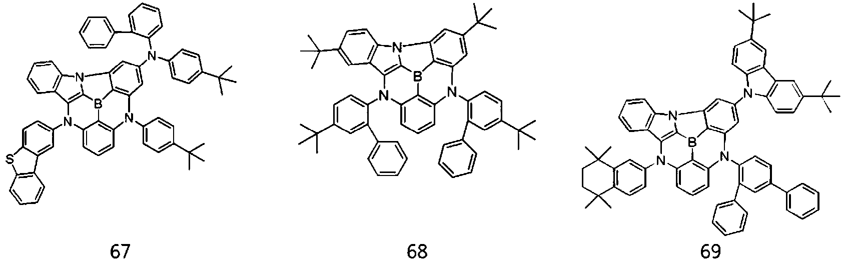

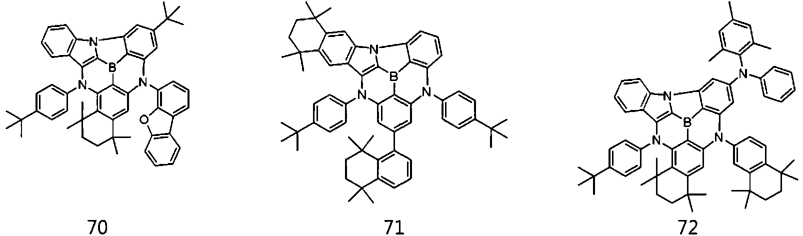

3. Dispositif électroluminescent organique comprenant une première électrode, une deuxième électrode, et une ou plusieurs couches organiques interposées entre les première et deuxième électrodes, une des couches organiques comprenant le composé organique représenté par la Formule A selon la revendication 1.

4. Dispositif électroluminescent organique selon la revendication 3, dans lequel les couches organiques comprennent une couche d'injection d'électrons, une couche de transport d'électrons, une couche d'injection de trous, une couche de transport de trous, une couche de blocage d'électrons, une couche de blocage de trous, et/ou une couche d'émission de lumière, au moins une de celles-ci comprenant le composé organique représenté par la Formule A.

5. Dispositif électroluminescent organique selon la revendication 4, dans lequel la couche d'émission de lumière est constituée d'un hôte et du composé représenté par la Formule A en tant que dopant.

6. Dispositif électroluminescent organique selon la revendication 5, dans lequel ledit hôte est un composé d'anthracène représenté par la Formule C : 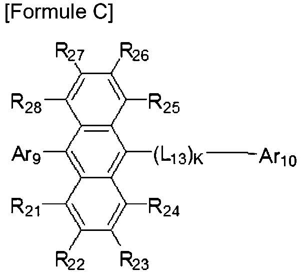 R₂₁ to R₂₈ étant identiques ou différents les uns des autres et étant tels que définis pour R dans la Formule A, Ar₉ et Ar₁₀ étant identiques ou différents les uns des autres et étant chacun indépendamment choisis parmi hydrogène, deutérium, alkyle en C₁-C₃₀ substitué ou non substitué, aryle en C₆-C₅₀ substitué ou non substitué, alcényle en C₂-C₃₀ substitué ou non substitué, alcynyle en C₂-C₂₀ substitué ou non substitué, cycloalkyle en C₃-C₃₀ substitué ou non substitué, cycloalcényle en C₅-C₃₀ substitué ou non substitué, hétéroaryle en C₂-C₅₀ substitué ou non substitué, hétérocycloalkyle en C₂-C₃₀ substitué ou non substitué, alcoxy en C₁-C₃₀ substitué ou non substitué, aryloxy en C₆-C₃₀ substitué ou non substitué, alkylthioxy en C₁-C₃₀ substitué ou non substitué, arylthioxy en C₆-C₃₀ substitué ou non substitué, halogène, amine substituée ou non substituée, et silyle substitué ou non substitué, L₁₃ étant une liaison simple ou étant choisi parmi arylène en C₆-C₂₀ substitué ou non substitué et hétéroarylène en C₂-C₂₀ substitué ou non substitué, et k étant un nombre entier de 1 à 3, pourvu que, lorsque k est égal ou supérieur à 2, les lieurs L₁₃ sont identiques ou différents les uns des autres.

7. Dispositif électroluminescent organique selon la revendication 6, dans lequel Ar₉ dans la Formule C est un groupe phényle substitué ou non substitué ou un groupe naphtyle substitué ou non substitué.

8. Dispositif électroluminescent organique selon la revendication 6, dans lequel le dérivé de l'anthracène représenté par la Formule C est choisi parmi les composés des Formules C1 à C69 :

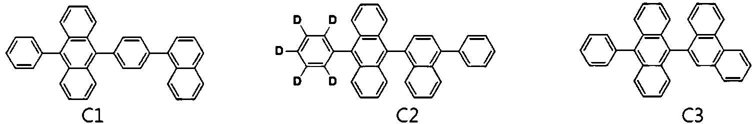

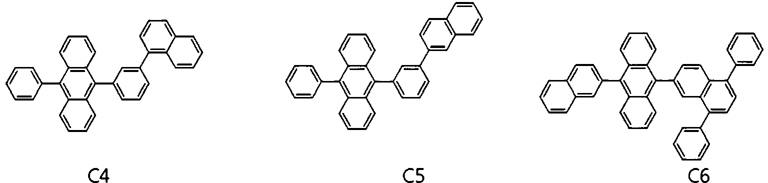

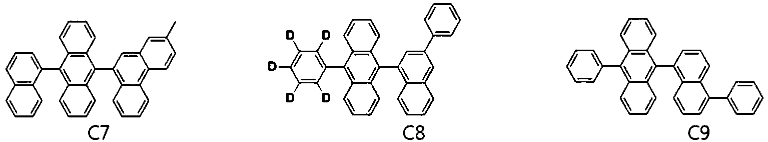

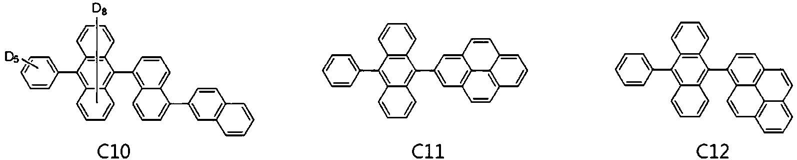

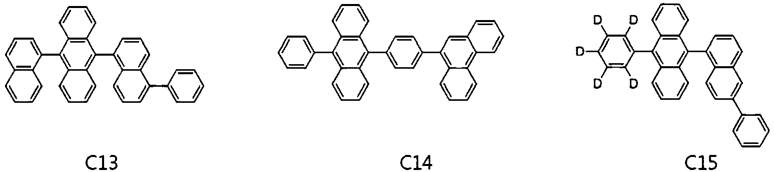

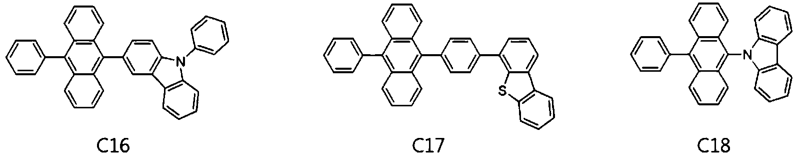

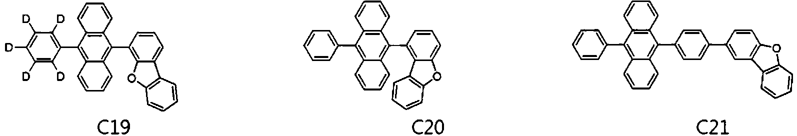

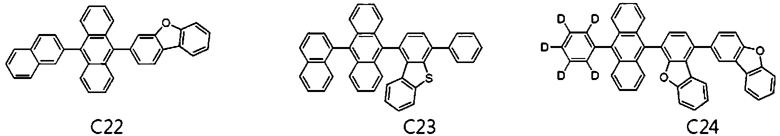

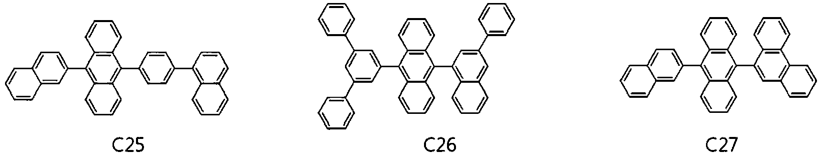

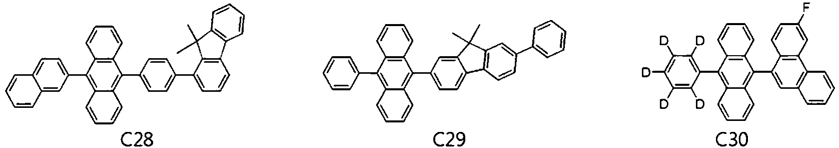

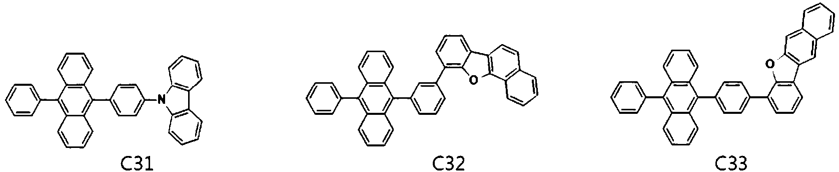

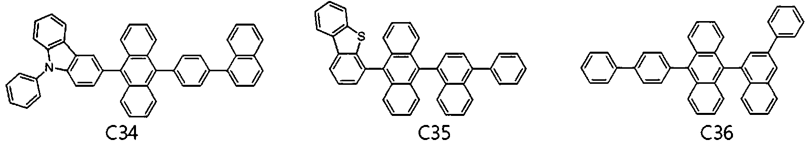

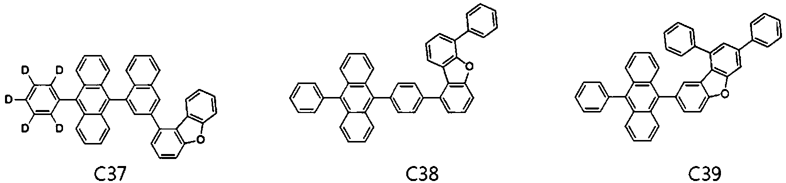

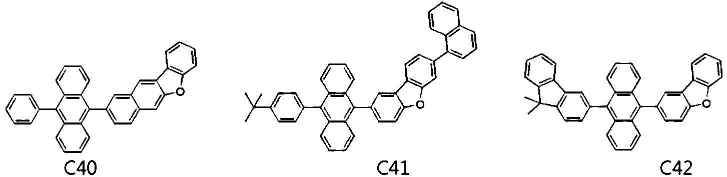

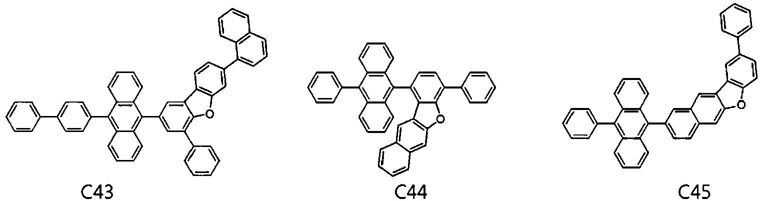

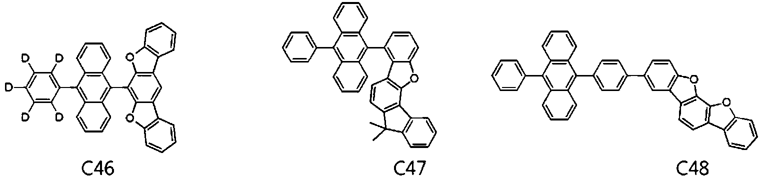

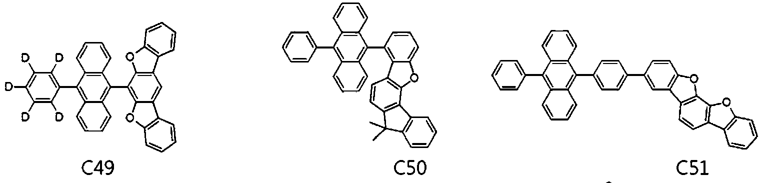

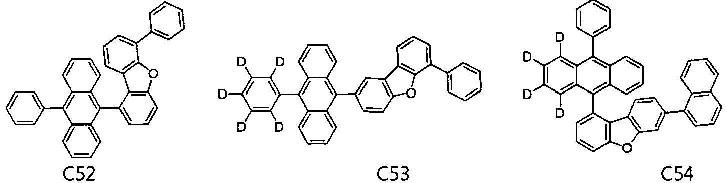

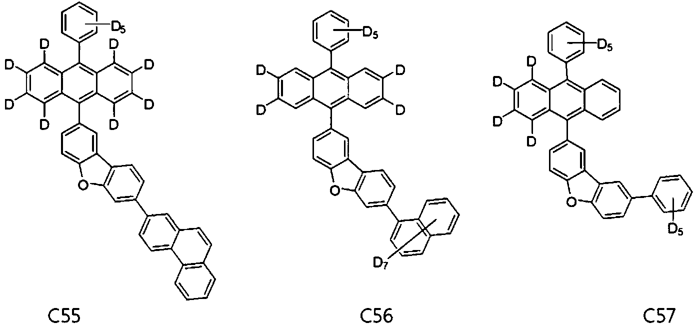

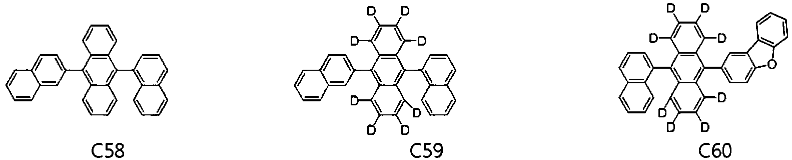

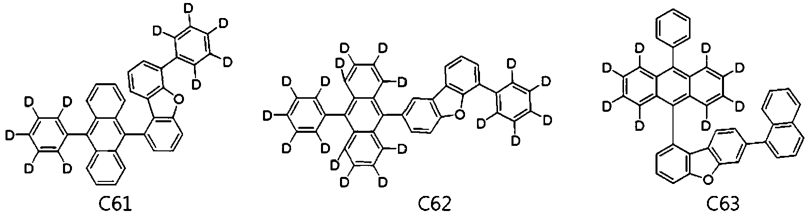

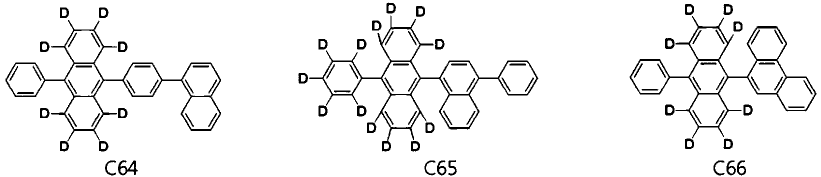

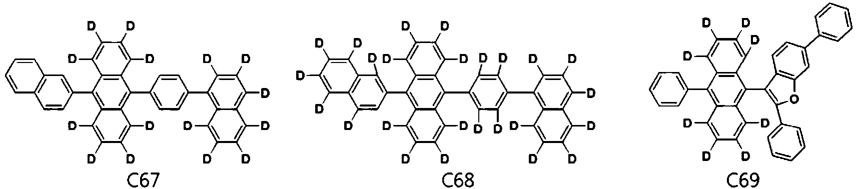

9. Dispositif électroluminescent organique selon la revendication 4, dans lequel une ou plusieurs des couches sont formées par un processus de déposition ou un processus de solution.

10. Dispositif électroluminescent organique selon la revendication 3, ledit dispositif électroluminescent organique étant utilisé dans un système d'affichage ou d'éclairage choisi parmi des écrans à panneau plat, des écrans flexibles, des systèmes d'éclairage monochromatique à panneau plat, des systèmes d'éclairage blanc à panneau plat, des systèmes flexibles d'éclairage monochromatique, et des systèmes flexibles d'éclairage blanc.
